# FASCICULE DE BREVET EUROPEEN

(11) **EP 2 964 564 B1**
(45) Date de publication et mention de la délivrance du brevet: **09.01.2019**
(21) Numéro de dépôt: 14711001.9
(22) Date de dépôt: 27.02.2014
(51) Int. Cl.: B81C 1/00

(54) **MICRO/NANO STRUCTURES DE NANOPARTICULES COLLOÏDALES FIXÉES SUR UN SUBSTRAT ÉLECTRET ET PROCÉDÉ DE FABRICATION DE TELLES MICRO/NANO STRUCTURES**
MIKRO-/NANOSTRUKTUREN AUS AN EIN ELEKTRETSUBSTRAT GEBUNDENEN KOLLOIDALEN NANOPARTIKELN UND VERFAHREN ZUR HERSTELLUNG SOLCHER MIKRO-/NANOSTRUKTUREN
MICRO/NANO STRUCTURES OF COLLOIDAL NANOPARTICLES ATTACHED TO AN ELECTRET SUBSTRATE AND METHOD FOR PRODUCING SUCH MICRO/NANO STRUCTURES

(30) Priorité: 08.03.2013 FR 1352092
(43) Date de publication de la demande: 13.01.2016
(73) Titulaire: Institut National des Sciences Appliquées de Toulouse, 31077 Toulouse Cedex 4 (FR); Centre National de la Recherche Scientifique (C.N.R.S.), 75016 Paris (FR); Université Paul Sabatier Toulouse III, 31062 Toulouse Cedex 9 (FR)
(72) Inventeur: RESSIER, Laurence, 31520 Ramonville Saint Agne (FR); NERALAGATTA MUNIKRISHNAIAH, Sangeetha, Bangalore 560 094 (IN); MOUTET, Pierre, 31000 Toulouse (FR)
(74) Mandataire: Gevers & Orès
(86) Numéro de dépôt international: PCT/IB2014/059308
(87) Numéro de publication internationale: WO 2014/136023

(56) Documents cités:
- PALLEAU E ET AL: "Quantification of the electrostatic forces involved in the directed assembly of colloidal nanoparticles by AFM nanoxerography;Quantification of the electrostatic forces involved in the directed assembly of colloidal nanoparticles by AFM nanoxerography", NANOTECHNOLOGY, IOP, BRISTOL, GB, vol. 22, no. 32, 19 juillet 2011 (2011-07-19), page 325603, XP020208816, ISSN: 0957-4484, DOI: 10.1088/0957-4484/22/32/325603
- CHAD R BARRY ET AL: "Printing nanoparticles from the liquid and gas phases using nanoxerography; Printing nanoparticles from the liquid and gas phases using nanoxerography", NANOTECHNOLOGY, IOP, BRISTOL, GB, vol. 14, no. 10, 27 août 2003 (2003-08-27) , pages 1057-1063, XP020067644, ISSN: 0957-4484, DOI: 10.1088/0957-4484/14/10/301
- ETIENNE PALLEAU ET AL: "Coulomb Force Directed Single and Binary Assembly of Nanoparticles from Aqueous Dispersions by AFM Nanoxerography", ACS NANO, vol. 5, no. 5, 24 mai 2011 (2011-05-24), pages 4228-4235, XP055090124, ISSN: 1936-0851, DOI: 10.1021/nn2011893
- RESSIER L ET AL: "How to Control AFM Nanoxerography for the Templated Monolayered Assembly of 2 nm Colloidal Gold Nanoparticles", IEEE TRANSACTIONS ON NANOTECHNOLOGY, IEEE SERVICE CENTER, PISCATAWAY, NJ, US, vol. 8, no. 4, juillet 2009 (2009-07), pages 487-491, XP011335100, ISSN: 1536-125X, DOI: 10.1109/TNANO.2009.2016089
- TYLER BLUMENTHAL ET AL: "Paper;Patterned direct-write and screen-printing of NIR-to-visible upconverting inks for security applications;Patterned direct-write and screen-printing of NIR-to-visible upconverting inks for security applications", NANOTECHNOLOGY, IOP, BRISTOL, GB, vol. 23, no. 18, 13 avril 2012 (2012-04-13), page 185305, XP020222418, ISSN: 0957-4484, DOI: 10.1088/0957-4484/23/18/185305

## Description

La présente invention concerne des micro/nano structures se présentant sous la forme d'un assemblage monocouche ou multicouches de nanoparticules colloïdales fixées sur un substrat électret, arrangées de manière compacte, et des procédés de fabrication de ces micro/nano structures.

Dans tout le texte on désigne par « matériau électret » tout matériau susceptible de conserver, pendant au moins une certaine durée, une polarisation électrique induite par un champ électrique, après annulation dudit champ électrique.

Dans tout le texte, des nanoparticules colloïdales sont des corps solides, ayant au moins l'une des dimensions comprise entre 1 et 1000 nm, formant une phase discrète dispersée dans un milieu continu ou dispersant de constitution différente, sans être dissous par lui. Des nanoparticules colloïdales peuvent être en particulier des nanocristaux colloïdaux.

Dans tout le texte, on désigne par nanoparticule colloïdale « chargée » toute nanoparticule colloïdale chargée électriquement, susceptible d'être piégée sous l'action de forces Coulombiennes ou électrophorétiques par un champ électrique généré par des motifs de charges inscrits à la surface d'un substrat électret.

Dans tout le texte, on désigne par nanoparticule colloïdale « neutre polarisable » toute nanoparticule colloïdale neutre ou quasi neutre électriquement, susceptible d'être polarisée électriquement lorsqu'elle est soumise à l'action d'un champ électrique externe, et susceptible d'être piégée sous l'action uniquement des forces diélectrophorétiques par un champ électrique généré par des motifs de charges inscrits à la surface d'un substrat électret.

Les nanocristaux colloïdaux NaYF₄ à maille hexagonale et dopés avec des lanthanides ont déjà fait la preuve de leur grand intérêt en raison de leur capacité à convertir efficacement un rayonnement proche de l'infrarouge et de faible énergie en un rayonnement visible de luminescence d'énergie plus élevée, ce type de conversion étant connu sous la dénomination conversion haute (en anglais upconversion) ou élévatrice en termes de fréquences. En plus de l'attrait fourni par des propriétés optiques uniques telles que des bandes d'émission étroites, des durées de vie d'états excités longues et une réponse photonique stable, la conversion haute des nanocristaux colloïdaux NaYF₄ dopés avec des lanthanides Ln³⁺ présentent des applications prometteuses dans les domaines des lasers solides, de l'imagerie infrarouge de faible intensité, des capteurs, du marquage sécuritaire, des afficheurs et des dispositifs photovoltaïques.

Afin d'exploiter les propriétés optiques des nanocristaux colloïdaux NaYF₄ dopés avec des lanthanides, plusieurs procédés ont été développés pour assembler les nanocristaux colloïdaux en des micro motifs sur des surfaces. Ces procédés dépourvus d'inscription de motifs de charges en surface sont par exemple le micro contact mécanique (µCP) combiné avec des « figures soufflées » par des gouttes d'eau, la photo formation de motifs utilisant une réaction d'amplification chimique, le micro moulage dans des éléments capillaires (MIMIC) utilisant des sphères de polystyrène, la lithographie colloïdale.

Toutefois, ces procédés présentent les inconvénients selon lesquels (i) la hauteur des assemblages de nanocristaux colloïdaux n'est pas maîtrisée et commandée avec précision, (ii) la résolution spatiale des motifs de nanocristaux colloïdaux créés est limitée, (iii) les géométries des motifs sont limitées et comportent des défauts, (iv) la durée de mise en oeuvre des procédés est élevée, et (v) des micro motifs contrôlés spatialement avec deux types de nanocristaux (assemblages binaires) ne peuvent pas être réalisés.

Depuis quelques années, la nanoxérographie par microscopie à force atomique AFM (en anglais Atomic Force Microsocopy) s'est révélée être une technique innovante pour la fabrication d'assemblages dirigés de colloïdes sur des surfaces.

Cette technique utilise des motifs de charges électriques inscrits sur des électrets par une pointe AFM pour piéger de manière électrostatique des nanoparticules colloïdales à partir de leurs dispersions.

Toutefois, les assemblages réalisés par cette technique jusqu'à ce jour sont limités à des assemblages monocouches et ces assemblages manquent en général de compacité en présentant des lacunes non souhaitées de tailles supérieures à la taille de deux nanoparticules adjacentes, limitant sérieusement ainsi leur application potentielle.

L'article de Shien-Der Tzeng et al. intitulé « Templated self-assembly of colloidal nanoparticles controlled by electrostatic nanopatterning on a Si3N4/SiO2/Si electret" publié dans la revue Advanced Materials, 2006, N°18, pp. 1147-1151, décrit un assemblage monocouche de nanoparticules d'or chargées positivement ayant une compacité élevée. Cet assemblage est obtenu par l'action de forces électrophorétiques exercées entre des motifs de charges négatives inscrits à la surface du substrat électret et des nanoparticules d'or chargées positivement. L'article PALLEAU E ET AL: "Quantification of the electrostatic forces involved in the directed assembly of colloidal nanoparticles by AFM nanoxerography", NANOTECHNOLOGY, IOP, BRISTOL, GB, vol. 22, no. 32, 19 juillet 2011, page 325603, décrit un procédé de fabrication d'une nano structure formée de nanoparticules colloïdales comprenant un assemblage monocouche de nanoparticules colloïdales fixées sur un substrat électret, ayant une forme géométrique, librement choisie et prédéterminée, comprenant les étapes consistant à :dans une première étape, fournir un substrat électret, constitué en un matériau électret et ayant une surface libre de réception, puis dans une deuxième étape, inscrire un potentiel électrique de surface sur la surface de réception du substrat électret suivant un motif prédéterminé de charges électriques correspondant à l'assemblage monocouche de nanoparticules, puis dans une troisième étape, mettre en contact le substrat électret ayant la surface de réception inscrite par le potentiel de surface suivant le motif souhaité de charges électriques, avec une dispersion colloïdale, la dispersion colloïdale comportant des nanoparticules colloïdales sensiblement neutres et polarisables électriquement sous l'action d'un champ électrique externe, et un milieu de dispersion, sous la forme d'un solvant liquide, sensiblement dépourvu d'action de polarisation électrique, dans lequel les nanoparticules colloïdales sont dispersées et les nanoparticules étant liées au substrat sous l'action de forces diélectrophorétiques, créées à partir de l'interaction entre les nanoparticules polarisables et le potentiel de surface inscrit.

Un premier problème technique est de disposer d'un procédé de fabrication d'assemblages dirigés mono ou multicouches de nanoparticules colloïdales, entassées au plus près pour améliorer la maîtrise de la compacité d'au moins la première couche en termes d'absence de lacunes non souhaitées de tailles supérieures ou égales à la taille de deux nanoparticules adjacentes, de préférence à la taille d'une particule.

Un deuxième problème technique, connexe au premier problème, est de disposer d'un procédé de fabrication d'assemblages binaires, dirigés mono ou multicouches de nanoparticules colloïdales de deux types différents, entassées au plus près pour assurer une compacité maîtrisée d'au moins la première couche en termes d'absence de lacunes non souhaitées de tailles supérieures ou égales à la taille de deux nanoparticules adjacentes, de préférence à la taille d'une particule.

A cet effet, l'invention a pour objet un procédé de fabrication d'une micro/nano structure formée de nanoparticules colloïdales comprenant un assemblage monocouche ou multicouches de nanoparticules colloïdales fixées sur un substrat électret, ayant une forme géométrique, librement choisie et prédéterminée, comprenant les étapes consistant à :
dans une première étape, fournir un substrat électret, constitué en un matériau électret et ayant une surface libre de réception, puis
dans une deuxième étape, inscrire un potentiel électrique de surface sur la surface de réception du substrat électret suivant un motif prédéterminé de charges électriques positives et/ou négatives correspondant à l'assemblage monocouche ou multicouches de nanoparticules, puis
dans une troisième étape, mettre en contact le substrat électret ayant la surface de réception inscrite par le potentiel de surface suivant le motif souhaité de charges électriques, avec une dispersion colloïdale pendant une durée de mise en contact suffisamment longue et inférieure ou égale à quinze minutes,
dans lequel la dispersion colloïdale comporte des nanoparticules colloïdales sensiblement neutres et polarisables électriquement sous l'action d'un champ électrique externe, et un milieu de dispersion, sous la forme d'un solvant liquide ou d'un gaz, sensiblement dépourvu d'action de polarisation électrique, dans lequel les nanoparticules colloïdales sont dispersées, et
la valeur absolue du potentiel électrique de surface et la concentration en nanoparticules polarisables sont respectivement supérieures ou égales à un premier seuil de potentiel électrique de surface et à un deuxième seuil de concentration, les premier et deuxième seuils dépendant chacun de la nature du milieu de dispersion et de la nature des nanoparticules polarisables, de sorte que
après la première durée de mise en contact, la micro/nano structure obtenue est une micro/nano structure monocouche ou multicouches ayant la forme géométrique souhaitée et dont au moins la première couche est compacte en termes d'absence de lacunes non souhaitées de tailles supérieures ou égales à la taille de deux nanoparticules adjacentes, de préférence à la taille d'une nanoparticule, les nanoparticules étant liées entre elles et/ou au substrat sous l'action de forces diélectrophorétiques, créées à partir de l'interaction entre les nanoparticules polarisables et le potentiel de surface inscrit.

Suivant des modes particuliers de réalisation, le procédé de fabrication d'une micro/nano structure formée de nanoparticules colloïdales comporte une plusieurs des caractéristiques suivantes :
- l'assemblage de nanoparticules colloïdales fixées sur le substrat électret, ayant une forme géométrique, librement choisie et prédéterminée est un assemblage multicouches dont au moins la première couche est compacte, et
la valeur absolue du potentiel électrique de surface et la concentration en nanoparticules polarisables sont respectivement supérieures ou égales à un troisième seuil de potentiel électrique de surface et à un quatrième seuil de concentration, les troisième et quatrième seuils dépendant chacun de la nature du milieu dispersant et de la nature des nanoparticules polarisables, de sorte que
après la durée de mise en contact, la micro/nano structure obtenue est la micro/nano structure multicouches ayant la forme géométrique souhaitée, dont au moins la première couche est compacte en termes d'absence de lacunes non souhaitées de tailles supérieures ou égales à la taille de deux nanoparticules adjacentes, de préférence à la taille d'une nanoparticule, les nanoparticules étant liées entre elles et/ou au substrat sous l'action de forces diélectrophorétiques créées à partir de l'interaction entre les nanoparticules neutres et polarisables électriquement et le potentiel de surface inscrit ;
- l'assemblage de nanoparticules colloïdales fixées sur un substrat électret, ayant une forme géométrique, librement choisie et prédéterminée est un assemblage multicouches d'un certain nombre Nc de couches dont chacune des couches est compacte en termes d'absence de lacunes non souhaitées de tailles supérieures à la taille de deux nanoparticules adjacentes, de préférence à la taille d'une nanoparticule, et
la valeur absolue du potentiel électrique de surface et la concentration en nanoparticules polarisables sont respectivement supérieures ou égales à un cinquième seuil de potentiel électrique de surface et à un sixième seuil de concentration, les cinquième et sixième seuils dépendant chacun de la nature du milieu de dispersion, la nature des nanoparticules polarisables et du nombre de couches, de sorte que
après la durée de mise en contact, la micro/nano structure obtenue est la micro/nano structure multicouches ayant la forme géométrique souhaitée, dont toutes les couches sont compactes en termes d'absence de lacunes non souhaitées de taille supérieures ou égales à la taille de deux nanoparticules adjacentes, de préférence à la taille d'une nanoparticule, les nanoparticules étant liées entre elles et/ou au substrat sous l'action de forces diélectrophorétiques créées à partir de l'interaction entre les nanoparticules polarisables et le potentiel de surface inscrit ;

Suivant un premier mode de réalisation, l'invention a également pour objet un procédé de fabrication d'une micro/nano structure binaire formée de deux types de nanoparticules formée de deux types de nanoparticules colloïdales comprenant
un premier assemblage monocouche de nanoparticules colloïdales du premier type, fixées sur un substrat électret, et ayant une première forme géométrique, librement choisie et prédéterminée, et
un deuxième assemblage monocouche ou multicouches de nanoparticules colloïdales du deuxième type, fixées sur un substrat électret, et ayant une deuxième forme géométrique, librement choisie et prédéterminée, le procédé comprenant les étapes consistant à :
dans une première étape, fournir un substrat électret, constitué en un matériau électret et ayant une surface libre de réception, puis
dans une deuxième étape, inscrire séquentiellement ou en parallèle un potentiel électrique de surface sur la surface de réception du substrat électret suivant un motif prédéterminé de charges électriques ayant un premier signe et de charges électriques ayant un deuxième signe opposé au premier, le motif de charges étant composé d'un premier sous motif de charges du premier signe, correspondant au premier assemblage monocouche de nanoparticules de premier type, et d'un deuxième sous motif de charges du deuxième signe, correspondant au deuxième assemblage monocouche ou multicouches de nanoparticules de deuxième type,
dans une troisième étape, mettre en contact le substrat électret ayant la surface de réception inscrite par le potentiel de surface, avec une première dispersion colloïdale pendant une première durée de mise en contact,
la première dispersion colloïdale comportant des nanoparticules du premier type chargées électriquement selon le deuxième signe et un premier milieu de dispersion sous la forme d'un solvant liquide ou d'un gaz, et la première durée de mise en contact étant suffisamment longue pour laisser se former sur le premier sous-motif de charges inscrit dans le substrat électret le premier assemblage monocouche, ayant la première forme géométrique souhaitée, de nanoparticules du premier type liées au substrat sous l'action de forces électrophorétiques, créées à partir de l'interaction Coulombienne entre les nanoparticules de premier type et le potentiel de surface du premier sous-motif de charges, puis
dans une quatrième étape, sécher le substrat électret et le premier assemblage, formant ensemble une micro/nano structure intermédiaire de fin de troisième étape, en enlevant le premier milieu de dispersion, puis
dans une cinquième étape, mettre en contact la structure intermédiaire séchée avec une deuxième dispersion colloïdale pendant une deuxième durée de mise en contact,
la deuxième dispersion colloïdale comportant des nanoparticules colloïdales du deuxième type, sensiblement neutres et polarisables électriquement sous l'action d'un champ électrique externe, et un deuxième milieu de dispersion sous la forme d'un solvant liquide ou d'un gaz, sensiblement dépourvu d'action de polarisation électrique, dans lequel les nanoparticules colloïdales de deuxième type sont dispersées, et
la valeur absolue du potentiel électrique de surface et la concentration en nanoparticules de deuxième type étant respectivement supérieures ou égales à un premier seuil de potentiel électrique de surface et à un deuxième seuil de concentration, les premier et deuxième seuils dépendant chacun de la nature du deuxième milieu de dispersion et de la nature des nanoparticules de deuxième type polarisables, de sorte que
après la deuxième durée de mise en contact suffisamment longue et inférieure à 15 minutes, le deuxième assemblage obtenu est le deuxième assemblage monocouche ou multicouches ayant la deuxième forme géométrique souhaitée et dont au moins la première couche est compacte en termes d'absence de lacunes non souhaitées de taille supérieures ou égales à la taille de deux nanoparticules adjacentes, de préférence à la taille d'une nanoparticule, les nanoparticules étant liées entre elles et/ou au substrat sous l'action de forces diélectrophorétiques créées à partir de l'interaction entre les nanoparticules polarisables et le potentiel de surface du deuxième sous-motif.

Suivant une deuxième forme de réalisation, l'invention a également pour objet un procédé de fabrication d'une micro/nano structure binaire formée de deux types de nanoparticules colloïdales comprenant
un premier assemblage monocouche ou multicouches de nanoparticules colloïdales du premier type, fixées sur un substrat électret, et ayant une première forme géométrique, librement choisie et prédéterminée, et
un deuxième assemblage monocouche ou multicouches de nanoparticules colloïdales du deuxième type, fixées sur un substrat électret, et ayant une deuxième forme géométrique, librement choisie et prédéterminée, le procédé comprenant, les étapes consistant à :
dans une première étape, fournir un substrat électret, constitué en un matériau électret et ayant une surface libre de réception, puis
dans une deuxième étape, inscrire séquentiellement ou en parallèle un premier potentiel électrique de surface sur la surface de réception du substrat électret suivant un premier sous-motif prédéterminé de charges électriques ayant un premier signe, correspondant au premier ensemble de nanoparticules du premier type, le premier sous-motif composant une première partie d'un motif de charge qui comporte également un deuxième sous-motif prédéterminé de charges électriques ayant un deuxième signe opposé au premier signe,
dans une troisième étape, mettre en contact le substrat électret ayant la surface de réception inscrite par le premier potentiel de surface, avec une première dispersion colloïdale pendant une première durée de mise en contact inférieure ou égale à 15 minutes,
la première dispersion colloïdale comportant des nanoparticules du premier type soit chargées électriquement selon le deuxième signe, soit sensiblement neutres et polarisables électriquement, et un premier milieu de dispersion sous la forme d'un solvant liquide ou d'un gaz, et la première durée de mise en contact étant suffisamment longue pour laisser se former sur le premier sous-motif de charges inscrit dans le substrat électret le premier ensemble ayant la première forme géométrique monocouche ou multicouches de nanoparticules du premier type liées au substrat, soit sous l'action de forces électrophorétiques, créées à partir de l'interaction Coulombienne entre les nanoparticules de premier type et le potentiel de surface du premier sous-motif de charges lorsque des nanoparticules du premier type sont chargées électriquement selon le deuxième signe, soit sous l'action de forces diélectrophorétiques créées à partir de l'interaction entre les nanoparticules polarisables et le potentiel de surface du premier sous-motif de charges lorsque les nanoparticules du premier type sont sensiblement neutres et polarisables électriquement,
dans une quatrième étape, sécher le substrat électret et le premier ensemble, formant ensemble une micro/nano structure intermédiaire de fin de troisième étape, puis
dans une cinquième étape, inscrire séquentiellement ou en parallèle un deuxième potentiel électrique de surface sur la surface de réception du substrat électret de la structure intermédiaire séchée et en dehors des zones recouvertes par le premier ensemble, suivant le deuxième sous-motif prédéterminé de charges électriques ayant le deuxième signe, puis
dans une sixième étape, mettre en contact la structure intermédiaire inscrite par le deuxième potentiel de surface avec une deuxième dispersion colloïdale pendant une deuxième durée de mise en contact,
la deuxième dispersion colloïdale comportant des nanoparticules colloïdales du deuxième type, neutres ou quasi-neutres électriquement et électriquement polarisables sous l'action d'un champ électrique externe, et un deuxième milieu dispersant, sous la forme d'un solvant liquide ou d'un gaz, sensiblement dépourvu d'action de polarisation électrique dans lequel les nanoparticules colloïdales sont dispersées, et
la valeur du potentiel électrique de surface et la concentration en nanoparticules de deuxième type étant respectivement supérieures ou égales à un premier seuil de potentiel électrique de surface et à un deuxième seuil de concentration, les premier et deuxième seuils dépendant chacun de la nature du deuxième milieu de dispersion et de la nature des nanoparticules de deuxième type polarisables, de sorte que
après la deuxième durée de mise en contact, le deuxième assemblage obtenu est le deuxième ensemble monocouche ou multicouches ayant la deuxième forme géométrique souhaitée et dont au moins la première couche est compacte en termes d'absence de lacunes non souhaitées de taille supérieure ou égales à la taille de deux nanoparticules adjacentes du deuxième type, de préférence à la taille d'une nanoparticule du deuxième type, les nanoparticules étant liées entre elles et/ou au substrat sous l'action de forces diélectrophorétiques créées à partir de l'interaction entre les nanoparticules polarisables et le potentiel de surface du deuxième sous-motif.

Suivant des modes particuliers de réalisation, les procédés de fabrication d'une micro/nano structure binaire formée de deux types de nanoparticules colloïdales décrits ci-dessus comportent une plusieurs des caractéristiques suivantes :
- les nanoparticules colloïdales du premier type possèdent la propriété de convertir un rayonnement dans un spectre proche de l'infrarouge (NIR) en un rayonnement dans un premier spectre du visible, et les nanoparticules du deuxième type portent possèdent la propriété de convertir le même rayonnement dans le spectre proche de l'infrarouge (NIR) en un rayonnement dans un deuxième spectre du visible, le premier spectre du visible étant différent du deuxième spectre du visible.
- la concentration en nanoparticules chargées du premier type, le premier milieu de dispersion, les nanoparticules du premier type en termes de taille, le premier sous-motif de charges, la première durée de mise en contact, la concentration en nanoparticules polarisables du deuxième type, le deuxième milieu de dispersion, les nanoparticules du deuxième type en termes de taille et de polarisabilité, et la deuxième durée de mise en contact sont choisis pour obtenir le premier assemblage ayant la première forme géométrique et le deuxième assemblage ayant la deuxième forme géométrique souhaitée, les première et deuxième formes géométrique étant des formes conjuguées et ayant une même hauteur par rapport à la surface de réception du substrat, de sorte que la forme géométrique du premier ensemble et la forme géométrique du deuxième ensemble séparé sont indétectables topographiquement par AFM ou par une microscopie optique utilisant un éclairement dans spectre du visible.

Suivant des modes particuliers de réalisation, les procédés de fabrication d'une micro/nano structure de nanoparticules colloïdales décrits ci-dessus comportent une plusieurs des caractéristiques suivantes :
- l'étape d'inscription du potentiel électrique de surface sur la surface de réception du substrat électret suivant un motif de charges est réalisé au choix,
   par un procédé d'inscription séquentielle de charges positives et/ou négatives sur le substrat électret compris dans l'ensemble formé par une inscription de charges électriques par un faisceau d'ions focalisés, une inscription de charges électriques par un faisceau d'électrons focalisés, une inscription de charges électriques par microscopie à force atomique (AFM) et une inscription de charges électriques par électrophotographie,
   par un procédé d'inscription en parallèle de charges positives et/ou négatives sur le substrat électret compris dans l'ensemble formé par la nano impression électrique et le microcontact électrique.
- le matériau électret est un matériau compris dans l'ensemble formé par les poly-méthacrylates de méthyle (PMMA), les copolymères d'oléfines cycliques (CoC), les polyéthylènes téré-phtalate (PET), les Polydiméthylsiloxanes (PDMS), les polypropylènes (PP), les polycarbonates (PC), les polystyrènes (PS), les polychlorures de vinyle (PVC), les polytétrafluoroéthylènes (PFTE), le sulfate de triglycine (TGS), le fluorure polyvinylidène (PVDF), le nitrure d silicium (Si₃N₄), l'oxyde de silicium (SiO₂), le composé Si₃N₄/SiO₂/Si (NOS) ;
   les nanoparticules colloïdales sensiblement neutres et polarisables électriquement sont des composés stabilisés par eux-mêmes ou par des ligands et/ou des charges, ayant des propriétés physiques comprises dans l'ensemble formé par les propriétés plasmoniques, conductrices, magnétiques, luminescentes, catalytiques, électrochromiques, photochromiques rendus sensiblement neutres et polarisables électriquement, réalisés à partir de nano particules colloïdales de base,
   les nanoparticules colloïdales de base possédant un coeur solide et le cas échéant une coquille, et étant comprises dans l'ensemble formé par le latex, SiO₂, TiO₂, ZrO₂ ; CdS, CdSe, PbSe, GaAs, GaN, InP, In₂O₃, ZnS, ZnO, MoS₂, Si, C, ITO ,Fe₂O₃, Fe₃O₄, Co, Fe-Co, Fe₃C, Fe₅C₂, Ni ; Au, Ag, Cu, Pt, et les nanoparticules bi-métailiques ; WO₃ ; NaLnF₄, les fluorures de lanthanide (LnF₃), les oxydes de lanthanides (Ln₂O₃), les zirconates, silicates, hydroxydes (Ln(OH)₃) et les sulfures d'oxydes dopés ou non avec un ou plusieurs lanthanides différents (Ln désignant un lanthanide), les mélanges de ces composés et le milieu dispersant des nanoparticules polarisables est au choix un solvant liquide ou un gaz non polarisant,
   le solvant liquide étant compris dans l'ensemble formé par le pentane, l'iso-pentane, l'hexane, l'heptane, l'octane, le nonane, le décane, le cyclopentane, le cyclohexane, le cycloheptane, le cyclooctane, le cyclohéxène, le benzène, le toluène, le méthylcyclohexane, le xylène, le mésithylène, le chloroforme, le chlorure de méthylène, le tétrachloroéthylène,
   le gaz dispersant non polarisant étant compris dans l'ensemble formé par le diazote N₂, l'argon Ar, et l'air ; et
- le procédé de fabrication d'une micro/nanostructure de nanoparticules colloïdales défini ci-dessus comprend les étapes supplémentaires consistant à :
   choisir et repérer par des coordonnées spatiales sur le substrat électret où l'assemblage a été formé une zone de surface non recouverte par l'assemblage sur laquelle des nanoparticules se sont fixées de manière fortuite et non maîtrisée, sous la forme d'une structure résultante d'un bruit de dépôt, ayant une répartition peu dense en terme de compacité, aléatoire et dépendante de l'échantillon du substrat électret sur lequel a été formé l'assemblage, puis
   capter une image de la structure aléatoire des nanoparticules déposées dans la zone de surface choisie et formant une signature, l'image captée étant au choix une image topograhique AFM, une image optique, ou une image de photoluminescence, puis
   sauvegarder dans une mémoire l'image captée et les coordonnées spatiales de la zone de surface correspondante.

L'invention a également pour objet une micro/nano structure formée de nanoparticules colloïdales comprenant
un substrat électret constitué en un matériau électret et ayant une surface libre de réception dans lequel est inscrit un potentiel électrique de surface sur la surface de réception du substrat électret suivant un motif de charges électriques positives et/ou négatives,
un assemblage de nanoparticules colloïdales fixées sur le substrat électret, ayant une forme géométrique,
dans lequel les nanoparticules colloïdales sont sensiblement neutres et polarisables électriquement sous l'action d'un champ électrique externe, et
les nanoparticules polarisables sont disposées en monocouche ou multicouches en étant liées directement entre elles et/ou au substrat sous l'action de forces diélectrophorétiques, créées par l'interaction existant entre les nanoparticules polarisables et le potentiel de surface du motif de charge, et
le motif de charges électriques de même polarité inscrit dans le substrat électret correspond à la forme géométrique de l'ensemble de nanoparticules monocouche ou multicouches, et
la valeur absolue du potentiel électrique de surface créé par le motif de charges est supérieure ou égale à un premier seuil de potentiel électrique de surface qui dépend de la nature des nanoparticules polarisables, et tel qu'au moins la première couche de l'ensemble de nanoparticules colloïdales est compacte en termes d'absence de lacunes non souhaitées de taille supérieure à la taille de deux nanoparticules adjacentes, de préférence à la taille d'une nanoparticule.

Suivant des modes particuliers de réalisation, la micro/nano structure formée de nanoparticules colloïdales comporte une plusieurs des caractéristiques suivantes :
la valeur absolue du potentiel électrique de surface créé par le motif de charges est supérieure ou égale à un troisième seuil qui dépend de la nature des nanoparticules polarisables, et tel que l'assemblage est multicouches.

L'invention a également pour objet une micro/nano structure formée de nanoparticules colloïdales de deux types différents comprenant sous la forme d'un assemblage binaire
un substrat électret constitué en un matériau électret et ayant une surface libre de réception,
un premier assemblage monocouche ou multicouches de nanoparticules colloïdales du premier type, fixées sur le substrat électret,
un deuxième assemblage monocouche ou multicouches de nanoparticules colloïdales du deuxième type, fixées sur le substrat électret,
dans lequel le substrat électret comprend un potentiel électrique de surface inscrit sur la surface de réception du substrat électret suivant un motif prédéterminé de charges électriques ayant un premier signe et ayant un deuxième signe opposé au premier signe, le motif de charges étant composé d'un premier sous motif de charges de premier signe et d'un deuxième sous motif de charge de deuxième signe, et
les nanoparticules du premier type formant le premier ensemble monocouche ou multicouches sont soit chargées électriquement selon le deuxième signe et liées au substrat électret sous l'action de forces Coulombiennes créées par l'interaction existant entre les nanoparticules de premier type et le potentiel de surface du premier sous-motif de charges inscrit dans le substrat électret, soit sensiblement neutres et polarisables électriquement et liées entre elles et/ou au substrat sous l'action de forces diéelectrophorétiques créées à partir de l'interaction existant entre les nanoparticules de Premier type et le potentiel de surface du premier sous-motif de charges inscrit dans le substrat électret, et
les nanoparticules colloïdales du deuxième type formant le deuxième ensemble monocouche ou multicouches, sont sensiblement neutres et polarisables électriquement sous l'action d'un champ électrique externe, sont liées entre elles et/ou au substrat sous l'action de forces diéelectrophorétiques créées à partir de l'interaction existant entre les nanoparticules de deuxième type et le potentiel de surface du deuxième sous-motif de charges inscrit dans le substrat électret, et
le deuxième sous motif de charges électriques de deuxième signe inscrit dans le substrat électret correspond à la forme géométrique du deuxième ensemble de nanoparticules monocouche ou multicouches, et
la valeur absolue du potentiel électrique de surface créé par le motif de charges est supérieure à un premier seuil de potentiel électrique de surface qui dépend de la nature des nanoparticules polarisables, et tel qu'au moins la première couche du deuxième ensemble de nanoparticules colloïdales est compacte en termes d'absence de lacunes non souhaitées de tailles supérieures ou égales à la taille de deux nano particules adjacentes, de préférence à la taille d'une nanoparticule.

Suivant des modes particuliers de réalisation, la micro/nano structure formée de nanoparticules colloïdales de deux types différents comporte une plusieurs des caractéristiques suivantes :
- les nanoparticules du premier type et les nanoparticules du deuxième type ont respectivement une première taille et une deuxième taille, et
les premier et deuxième ensembles possèdent respectivement un premier nombre et un deuxième nombre de couches, et
le produit du premier nombre de couches par la première taille et le produit du deuxième nombre de couches par la deuxième taille sont sensiblement égaux, et
les formes des premier et deuxième sous-motifs de tension en termes de codage d'intensité, de signe du potentiel sur la surface de réception du substrat électret sont configurées de sorte que les première et deuxième formes géométriques respectivement du premier ensemble et du deuxième ensemble sont des formes conjuguées et ont sensiblement une même hauteur par rapport à la surface de réception du substrat, rendant ainsi la forme géométrique du premier ensemble et la forme géométrique du deuxième ensemble indétectables séparément topographiquement par AFM et/ou par une microscopie optique utilisant un éclairement dans spectre du visible ; et
- les nanoparticules du premier type possèdent la propriété de convertir un rayonnement dans un spectre proche de l'infrarouge (NIR) en un rayonnement dans un premier spectre du visible, et les nanoparticules du deuxième type possèdent la propriété de convertir le même rayonnement dans le spectre proche de l'infrarouge (NIR) en un rayonnement dans un deuxième spectre du visible, le premier spectre du visible étant différent du deuxième spectre du visible.

L'invention a également pour objet une étiquette de marquage anti-contrefaçon et/ou de traçabilité et/ou d'authentification comprenant une micro/nano structure de nanoparticules colloïdales telle que définie ci-dessus ou obtenue par le procédé tel que défini ci-dessus.

L'invention sera mieux comprise et d'autres avantages de celle-ci apparaîtront plus clairement à la lecture de la description qui va suivre de plusieurs formes de réalisation de l'invention, donnée uniquement à titre d'exemple et faite en se référant aux dessins annexés dans lesquels :
- la Figure 1 est une vue d'un procédé de fabrication d'une micro/nano structure selon l'invention ;
- la Figure 2 est une vue par Microscopie à Force Kelvin (KFM en anglais pour Kelvin Force Microscopy) d'une série de lignes de charges électriques négatives et positives injectées dans un substrat électret ;
- les Figures 3 et 4 sont des images AFM et de microscopie à balayage électronique (SEM en anglais pour Scanning Electron Microscopy) d'assemblages de nanoparticules développés suivant les motifs de charges décrits à la Figure 2 à deux concentrations respectives C₀ et C₀/40 ;
- la Figure 5 est une vue de la relation existant entre la hauteur des assemblages de nanoparticules neutres polarisables et la valeur absolue du potentiel de surface des motifs de charges inscrits et ce pour différentes concentrations d'une même dispersion colloïdale ;
- la Figure 6 est une vue topographique d'un assemblage dirigé formé de nanoparticules chargées ;
- la Figure 7 est une vue de la corrélation existant entre la hauteur d'assemblages de nanoparticules luminescentes neutres polarisables et l'intensité relative de luminescence ;
- la Figure 8 est un ensemble d'une vue topographique AFM et d'une vue codée en intensité de luminescence d'un assemblage tridimensionnel de nanoparticules colloïdales luminescentes neutres et polarisables ;
- la Figure 9 est un ordinogramme d'un procédé selon l'invention de fabrication d'un assemblage dirigé de nanoparticules d'un même type;
- les Figures 10, 11, 12 sont les vues de différentes phases de réalisation d'un assemblage binaire de deux types de nanoparticules, respectivement l'image KFM d'un motif de charges composé d'un premier sous-motif et d'un deuxième sous motif de charges de signes opposés et de formes conjuguées, l'image topographique AFM du développement du premier sous-motif, et l'image topographique AFM du développement du motif entier dans lequel la frontière des premier et deuxième sous-motifs est indétectable ;
- les Figures 13, 14, 15 sont les cartographies de photoluminescence des assemblages de la Figure 12, respectivement adaptées au spectre optique des deux sous-motifs, au spectre optique du premier sous-motif seul, et au spectre du deuxième sous-motif seul;
- la Figure 16 est un ordinogramme d'une première forme de réalisation de fabrication d'un assemblage binaire selon l'invention ;
- la Figure 17 est une vue d'un timbre, utilisé pour inscrire en parallèle et successivement des charges d'un premier signe, puis des charges d'un deuxième signe, ou des charges de même type mais de densités différentes ;
- la Figure 18 est un ordinogramme d'une deuxième forme de réalisation de fabrication d'un assemblage binaire selon l'invention ;
- la Figure 19 est une vue par microscopie optique d'un QR (en anglais Quick Response) code tridimensionnel réalisé par un procédé de l'invention.

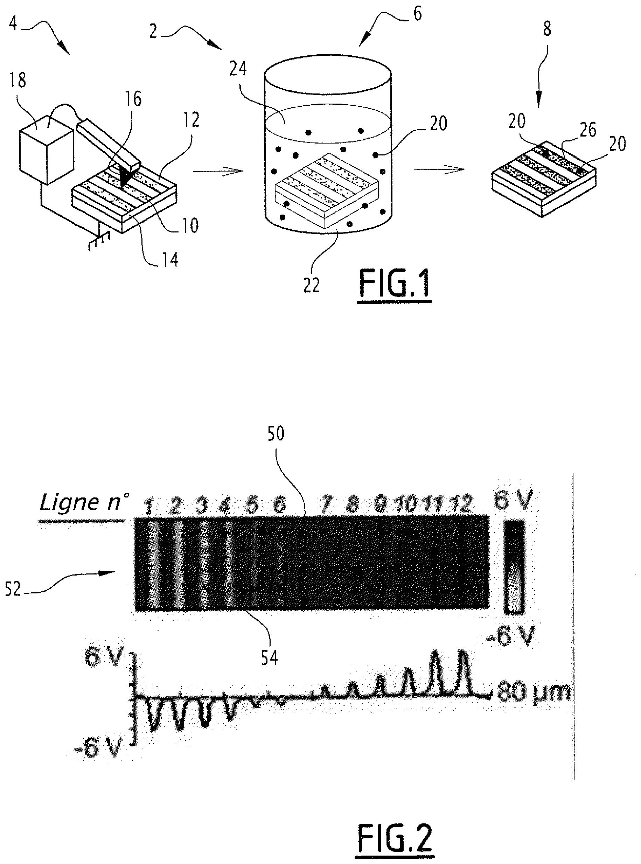

Suivant la Figure 1, un procédé 2 de nanoxérographie à microscopie par force atomique AFM, utilisé pour assembler de manière dirigée des nanocristaux colloïdaux β- NaYF₄, stabilisés par des oléates et dopés avec des lanthanides à partir de leurs dispersions dans de l'hexane, comprend une première étape 4, une deuxième étape 6 et une troisième étape 8, exécutées successivement.

Dans la première étape 4, des motifs 10 de charges électriques sont inscrits, en injectant séquentiellement suivant des points, des charges positives et/ou négatives sur une surface de réception 12 d'un substrat électret 14, ici un film de polyméthylméthacrylate (PMMA) de 100 nanomètres d'épaisseur, à l'aide d'une pointe AFM 16, polarisée sous des conditions ambiantes et alimentée par un générateur de tension 18.

La première étape 4 est exécutée pendant une durée d'écriture, comprise typiquement entre quelques secondes et quelques minutes, et dépendant de la complexité des motifs de charges inscrits

Dans la deuxième étape 6, le substrat électret 14 dont la surface de réception 12 est inscrite par les motifs 10 de charges électriques, est mis en contact pendant une durée de mise en contact, ici égale à 30 secondes, avec une dispersion 20 des nanocristaux colloïdaux 22, dispersés dans le solvant 24, ici de l'hexane.

La mise en contact représentée sur la figure 1 est réalisée ici par une immersion totale du substrat électret pendant une durée d'incubation dans la dispersion 20.

En variante, la mise en contact est réalisée par le dépôt d'une goutte du solvant dispersant sur la surface de réception inscrite par les motifs de charges électriques pendant une durée d'incubation. Cette variante est réalisée sous la réserve que la surface des motifs possède une taille compatible avec la taille de la goutte de solvant et que le solvant n'est pas trop volatile.

En variante, le solvant dispersant est remplacé par un gaz dispersant non polarisant.

Dans la troisième étape 8, le substrat électret 14 sur lequel ont été déposés des nanocristaux sous la forme de motifs linéaires 26, est séché sous des conditions ambiantes, c'est-à-dire sous une pression d'environ une atmosphère et une température voisine de 25°C.

Suivant la Figure 2, une carte 50 du potentiel de surface observé par Microscopie à Force Kelvin (KFM) comprend une suite 52 de 12 lignes 54 de potentiel de surface croissant algébriquement de gauche à droite sur la Figure 2, les lignes 54 de potentiel de surface étant numérotées de 1 à 12 en allant vers la droite de la Figure 2.

Les six premières lignes 1 à 6 de potentiel de surface correspondent à des charges négatives inscrites et les six dernières lignes 7 à 12 de potentiel de surface correspondent à des charges positives inscrites.

Les lignes 54 de potentiel de surface correspondent à des lignes écrites pendant l'étape 4 de la Figure 1 par la technique AFM en utilisant des impulsions de tension variant de -85V à +85V.

Il convient de remarquer que l'étape d'écriture 4 de charges électriques ne change pas la topographie du film électret PMMA.

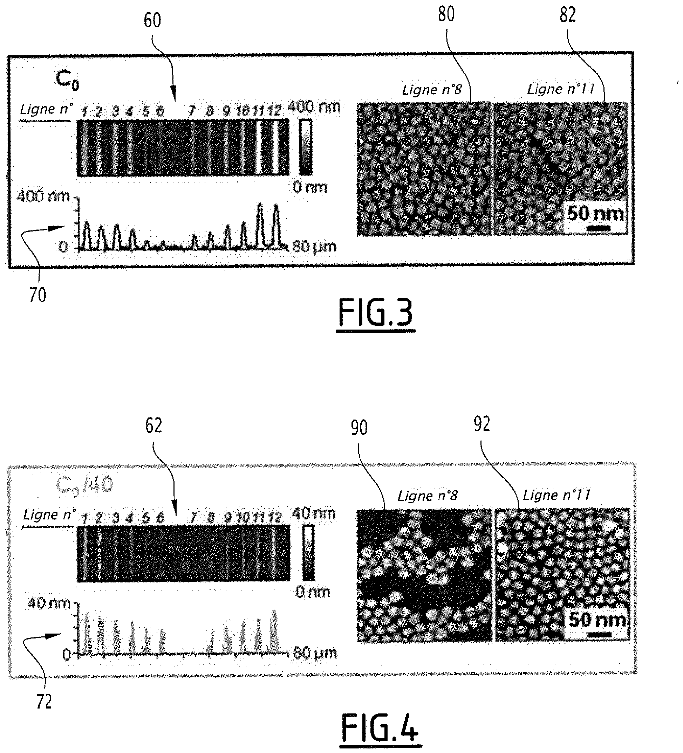

Suivant les Figures 3 et 4, les effets du potentiel de surface des motifs de charges et de la concentration des nanocristaux colloïdaux β-NaYF₄: Er³⁺,Yb³⁺ dispersés dans de l'hexane, sur les morphologies des assemblages de nanocristaux obtenus par le procédé 2 de la Figure 1, sont évalués et représentés.

Dans les Figures 3 et 4, la même carte de potentiel de surface telle que décrite dans la Figure 2 a été utilisée.

Dans les Figures 3 et 4, des nanocristaux β-NaYF₄: Er³⁺,Yb³⁺, de conversion haute dans le vert, de forme sphérique et de 22 nanomètres de diamètre, dispersés dans de l'hexane, sont utilisés pendant l'étape 6 de la Figure 1, à deux concentrations respectivement différentes, à C₀ égal à 7.8 × 10¹² NCs/mL pour la Figure 3, et à C₀/40 = 1.9 × 10¹¹ NCs/mL pour la Figure 4.

Chaque Figure 3 et 4, comporte respectivement une image topographique AFM 60, 62 de l'assemblage dirigé correspondant de nanocristaux, une analyse de la section transversale correspondante 70, 72, et deux images par microscopie à balayage électronique (SEM) 80, 82, 90, 92 de l'assemblage des nanoparticules sur deux lignes de charges représentatives, les lignes numérotées 8 et 11.

Suivant la Figure 3, lorsque les motifs de charge sont développés en utilisant des nanocristaux NaYF₄ à la concentration C₀ qui est suffisamment élevée pour considérer la dispersion comme un réservoir infini de nanocristaux colloïdaux, des assemblages multicouches et compacts de nanoparticules sont formés à la fois sur les lignes de charges positives et négatives, dont la hauteur moyenne augmente progressivement avec la valeur absolue du potentiel de surface des motifs de charges.

Suivant la Figure 4, lorsque la concentration de la dispersion en nanoparticules diminue d'un facteur de 40, c'est-à-dire est égale à C₀ / 40, seuls des assemblages monocouches de nanocristaux sont formés sur les lignes de charges positives et négatives, indépendamment de leur potentiels de surface. Cependant, une augmentation de la densité des nanocristaux a lieu lorsque la valeur absolue du potentiel de surface des lignes de charges augmente.

Comme représenté sur les images SEM 90, 92, ces assemblages monocouches de nanocristaux colloïdaux forment des îlots de nanoparticules colloïdales sur l'image 90 qui correspond à une ligne 8 de charges ayant un potentiel de surface strictement inférieur à un certain seuil, et forment un amas compact de nanoparticules colloïdales serrées au plus près sur l'image 92 qui correspond à une ligne 11 de charges ayant un potentiel de surface supérieur ou égal audit certain seuil.

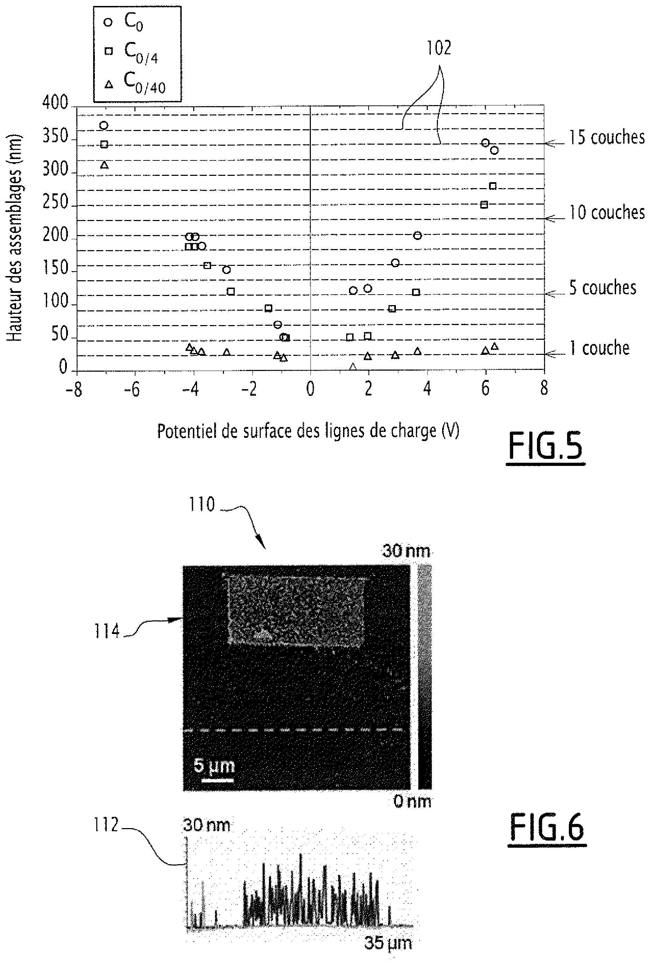

Suivant la Figure 5, il existe une relation de dépendance linéaire entre la hauteur moyenne des assemblages de nanocristaux colloïdaux et la valeur absolue du potentiel de surface des lignes de charges ainsi que la concentration en nanocristaux colloïdaux. La hauteur moyenne observée des assemblages de nanocristaux colloïdaux obtenus pour des concentrations de nanocristaux supérieures ou égales à C₀ correspond bien à la hauteur calculée théoriquement pour un remplissage compact de nanocristaux arrangés selon un agencement à maille cubique à face centrée ou un agencement à maille hexagonale, ces hauteurs théoriques étant représentées par des traits finement pointillés 102. La hauteur des assemblages peut être contrôlée et maîtrisée depuis une hauteur d'environ 25 nm, correspondant à une monocouche de nanocristaux colloïdaux NaYF₄ jusqu'à une hauteur maximale de 350 nm correspondant à quinze couches de nanocristaux colloïdaux NaYF₄ en raison de la limitation du potentiel de surface inscrit dans le cas présent. La concentration minimale de nanocristaux colloïdaux requise pour obtenir la hauteur maximale pour un potentiel de charge donné est égale à 3.9 × 10¹² NCs/mL dans ce cas.

Il est à remarquer que l'évolution de la hauteur moyenne des assemblages de nanoparticules colloïdales en fonction du potentiel de surface des lignes de charges est sensiblement symétrique des deux cotés positif et négatif de l'axe du potentiel. En d'autres termes, la hauteur de l'assemblage des nanoparticules colloïdales dépend de la valeur absolue du potentiel de surface des lignes de charge et ne dépend pas de son signe. Cela indique que les nanocristaux colloïdaux NaYF₄, quasi neutres électriquement ont été électriquement polarisés sous l'action du gradient du champ électrique, non uniforme et créé par les motifs de charge inscrits, et sont piégés par ces motifs sous l'action de forces diélectrophorétiques uniquement.

La Figure 6 comporte une image topographique AFM 110 et un tracé 112 de deux sections transversales, correspondant respectivement à un motif inscrit de charges négatives rectangulaire situé sur la moitié supérieure de la Figure 6 et à un motif inscrit de charges positives rectangulaire situé sur la moitié inférieure de la Figure 6.

Suivant la Figure 6 et de manière différente à ce qui est décrit dans les Figures 1 à 5, une solution de nanocristaux colloïdaux β-NaYF₄:Er³⁺,Yb³⁺ chargés positivement et dispersés dans de l'eau à une concentration de 1.0 × 10¹³ NCs/mL permet d'obtenir des assemblages dirigés monocouches de nanocristaux colloïdaux déposés seulement sur les motifs chargés négativement (i.e. de charge opposée aux nanocristaux), ici un seul motif 114 sur la Figure 6, indépendamment du potentiel de surface des motifs de charges ou de la concentration en nanocristaux colloïdaux. L'assemblage de nanocristaux colloïdaux dans ce cas est piloté exclusivement par des forces de Coulomb, c'est-à-dire une attraction des nanocristaux colloïdaux sur le motif de charges opposées et une répulsion des nanocristaux colloïdaux du motif de mêmes charges. A l'inverse de l'invention, ces assemblages ne sont jamais organisés en des structures compactes de nanoparticules colloïdales serrées au plus près, en raison des forces de répulsion électrostatique existantes entre les nanocristaux chargés.

Ainsi, suivant l'invention, la densité de nanoparticules colloïdales sur les motifs de charges varie avec et est réglée en fonction du potentiel de surface des motifs de charges et de la concentration en nanoparticules neutres polarisables électriquement.

Les résultats relatifs à l'invention, tels que décrits ci-dessus, indiquent que de manière générale un assemblage de nanocristaux colloïdaux β-NaYF₄, sensiblement neutres et polarisables électriquement, dirigés à partir de forces électrostatiques depuis leur dispersion jusqu'aux motifs de charges est régi par (i) le potentiel de surface du motif de charges, (ii) la concentration des nanocristaux dans la dispersion, (iii) la polarité du solvant de dispersion.

Ces résultats ne sont pas limités aux nanocristaux β-NaYF₄ et peuvent être généralisés à une liste plus large de nanoparticules colloïdales. La formation d'assemblages multicouches de nanoparticules n'est pas non plus limitée à des nanoparticules β-NaYF₄. Par exemple, des assemblages multicouches peuvent également être obtenus pour des nanoparticules d'or dispersées dans des dispersions d'hexane.

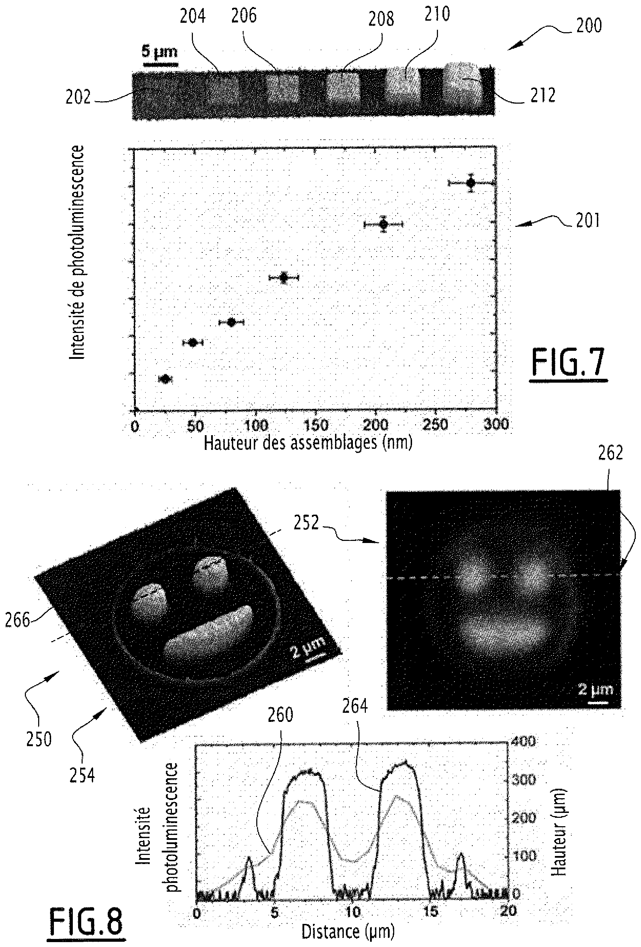

La Figure 7 comporte une image topographique AFM 200 de six assemblages de nanocristaux de β-NaYF₄ Er³⁺, Yb³⁺ neutres et polarisables de hauteurs différentes, et un tracé 201 d'évolution de l'intensité de photoluminescence en fonction de la hauteur de ces assemblages de nanocristaux photoluminescents.

Suivant la Figure 7 est ainsi illustrée la relation de dépendance existant entre la hauteur de six assemblages 202, 204, 206, 208, 210, 212 de nanocristaux colloïdaux β-NaYF₄ Er³⁺, Yb³⁺ et leur propriété de luminescence.

Les assemblages 202, 204, 206, 208, 210, 212 sont des assemblages de nanocristaux colloïdaux β-NaYF₄ Er³⁺, Yb³⁺ dirigés sur des motifs de charge inscrits sur des carrés de 5µm x 5µm dont les potentiels de surface augmentent de gauche à droite sur l'image 200 de la Figure 7. De manière correspondante, la hauteur des assemblages 202, 204, 206, 208, 210, 212 varie de 20 nm à 280 nm. La luminescence, résultant de la conversion haute des assemblages de nanoparticules lorsqu'ils sont excités par une diode laser à porteuse continue de 980 nm de longueur d'onde, correspond à celle obtenue à partir de dispersions utilisant l'hexane comme solvant dispersant. Comme représentée sur le tracé 201 de Figure 7, l'intensité de luminescence de la conversion haute dans le vert visible (correspondant à une longueur d'onde de 525/545 nm) des assemblages des nanocristaux colloïdaux augmente progressivement en fonction de leur hauteur. Clairement, l'intensité de luminescence résultant de la conversion haute augmente lorsque le nombre d'émetteurs, formés par les nanocristaux, augmente.

La maîtrise offerte par la nanoxérographie AFM sur l'architecture de l'assemblage, en termes d'une forme géométrique quelconque souhaitée du ou des motifs et de la hauteur de l'assemblage, en fait une technique adaptée à la construction d'étiquettes anti-contrefaçon et/ou de traçabilité et/ou d'authentification. La fonction d'anti-contrefaçon d'une étiquette lorsque l'étiquette est pourvue d'une telle fonction possède un ou plusieurs niveaux de sécurité élevé.

Suivant la Figure 8, une image topographique 250 par microscopie AFM et une image optique de luminescence 252 d'un assemblage 254 tridimensionnel multicouches de nanocristaux colloïdaux, présentant la forme originale d'un « Smiley », sont fournies.

Les nanocristaux colloïdaux de l'assemblage 254 sont des nanoparticules colloïdales β-NaYF₄ :Er³⁺, Yb³ de 22 nm de diamètre et stabilisées dans de l'oléate. Les nanocristaux sont déposés sur un motif de charges ayant la forme du « Smiley ».

Dans cet assemblage, la hauteur du contour et la hauteur des traits caractéristiques de la face du « Smiley » sont respectivement égales à 100 nm et 350 nm.

Suivant la Figure 8, sont fournis un tracé 260 de l'évolution de l'intensité de luminescence de l'assemblage 254 le long d'une ligne de coupe désignée par 262 sur l'image de photoluminescence 252, et un tracé 264 de la hauteur de l'assemblage le long de la même ligne de coupe correspondante désignée par 266 sur l'image topographique AFM 250.

Les intensités relatives de luminescence de conversion émises des parties différentes de l'assemblage sont très bien corrélées avec la hauteur mesurée par l'analyse de la section transversale de l'image topographique AFM selon le tracé 264.

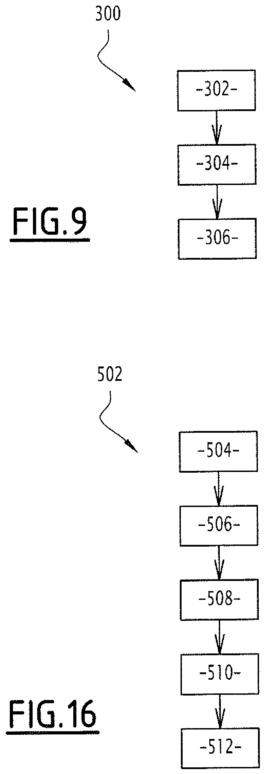

De manière générale et suivant la Figure 9, un procédé 300 de fabrication d'une micro/nano structure formée de nanoparticules colloïdales comprenant un assemblage monocouche ou multicouches de nanoparticules colloïdales fixées sur un substrat électret, ayant une forme géométrique librement choisie et prédéterminée, et dont au moins la première couche est compacte en termes d'absence de lacunes non souhaitées de tailles supérieures ou égales à la taille de deux nanoparticules adjacentes,de préférence à la taille d'une particule, comprend une succession d'étapes 302, 304, 306.

Dans une première étape 302, il est fourni un substrat électret, constitué en un matériau électret et ayant une surface libre de réception.

Puis, dans une deuxième étape 304, un potentiel électrique de surface est inscrit sur la surface de réception du substrat électret suivant un motif prédéterminé de charges électriques de même signe et/ou de signes opposés correspondant à l'ensemble monocouche ou multicouches de nanoparticules que l'on cherche à obtenir.

Ensuite, dans une troisième étape 306, le substrat électret, ayant la surface de réception inscrite par le potentiel de surface suivant le motif souhaité de charges électriques, est mis en contact avec une dispersion colloïdale pendant une durée de mise en contact.

La dispersion colloïdale comporte des nanoparticules colloïdales neutres ou quasi-neutres électriquement et électriquement polarisables sous l'action d'un champ électrique externe, et un milieu dispersant sous la forme d'un solvant liquide ou un gaz, sensiblement dépourvu d'action de polarisation électrique, dans lequel les nanoparticules colloïdales sont dispersées.

La valeur absolue du potentiel électrique de surface et la concentration en nanoparticules polarisables sont respectivement supérieures ou égales à un premier seuil de potentiel électrique de surface et un deuxième seuil de concentration, les premier et deuxième seuils dépendant chacun de la nature du milieu dispersant et de la nature des nanoparticules polarisables, de sorte qu'après une durée de mise en contact suffisamment longue et inférieure à 15 minutes, la micro/nano structure obtenue est une micro/nano structure monocouche ou multicouches ayant la forme géométrique souhaitée et dont au moins la première couche est compacte en termes d'absence de lacunes non souhaitées de tailles supérieures ou égales à la taille de deux nanoparticules adjacentes, de préférence à la taille d'une nanoparticule, les nanoparticules étant liées entre elles et/ou au substrat sous l'action de forces diélectrophorétiques, créées à partir de l'interaction entre les nanoparticules polarisables et le potentiel de surface inscrit.

En variante, la valeur absolue du potentiel électrique de surface et la concentration en nanoparticules polarisables sont respectivement supérieures ou égales à un troisième seuil de potentiel électrique de surface et à un quatrième seuil de concentration, les troisième et quatrième seuils dépendant chacun de la nature du milieu dispersant et de la nature des nanoparticules polarisables, de sorte qu'après une durée de mise en contact suffisamment longue et inférieure à quinze minutes, la micro/nano structure obtenue est la micro/nano structure multicouche ayant la forme géométrique souhaitée, dont au moins la première couche est compacte en termes d'absence de lacunes non souhaitées de tailles supérieures ou égales à la taille de deux nanoparticules adjacentes, de préférence à la taille d'une nanoparticule, les nanoparticules étant liées entre elles et/ou au substrat sous l'action de forces diélectrophorétiques créées à partir de l'interaction entre les nanoparticules neutres et polarisables électriquement et le potentiel de surface inscrit.

En variante, l'assemblage de nanoparticules colloïdales fixées sur un substrat électret, ayant une forme géométrique, librement choisie et prédéterminée est un assemblage multicouches d'un certain nombre N_{c} de couches dont chacune des couches est compacte en termes d'absence de lacunes non souhaitées de tailles supérieures ou égales à la taille de deux nanoparticules adjacentes, de préférence à la taille d'une nanoparticule.

Le potentiel électrique de surface et la concentration en nanoparticules polarisables sont respectivement supérieures ou égales à un cinquième seuil de potentiel électrique de surface et à un sixième seuil de concentration, les cinquième et sixième seuils dépendant chacun de la nature du milieu dispersant, la nature des nanoparticules polarisables et du nombre de couches, de sorte que après une durée de mise en contact suffisamment longue et inférieure à 15 minutes, la micro/nano structure obtenue est la micro/nano structure multicouches ayant la forme géométrique souhaitée, dont toutes les couches sont compactes, les nanoparticules étant liées entre elles et/ou au substrat sous l'action de forces diélectrophorétiques créées à partir de l'interaction entre les nanoparticules polarisables et le potentiel de surface inscrit.

Les nanoparticules colloïdales possèdent des propriétés physiques comprises dans l'ensemble formé par les propriétés plasmoniques, conductrices, magnétiques, luminescentes, catalytiques, électrochromiques et photochromiques.

Par exemple, les nanoparticules colloïdales portent chacune un lanthanide apte à convertir un rayonnement dans un spectre proche de l'infrarouge (NIR) en un rayonnement dans un spectre du visible.

En variante, l'étape d'inscription des motifs de charges sur la surface de réception du substrat électret peut être réalisé au choix par un procédé d'inscription séquentielle de charges électriques sur le substrat électret, ou un procédé d'inscription en parallèle de charges électriques sur le substrat électret.

Un procédé d'inscription séquentielle est compris dans l'ensemble formé par une inscription de charges électriques par un faisceau d'ions focalisés, une inscription de charges électriques par un faisceau d'électrons focalisés, une inscription de charges électriques par microscopie à force atomique (AFM), et une inscription de charges électriques par électrophotographie (dénommée encore xérographie).

Il est à remarquer que l'inscription de charges électriques par microscopie à force atomique (AFM) permet avantageusement d'inscrire en une seule étape ininterrompue ou en une seule passe un motif de charges comportant à la fois des charges positives et des charges négatives.

Un procédé d'inscription en parallèle est compris dans l'ensemble formé par la nano impression électrique et le micro contact électrique.

En variante, une zone de surface de l'échantillon du substrat électret sur lequel l'assemblage a été formé est choisie dans la surface de réception du substrat électret hors assemblage. Sur cette zone de surface choisie, lors de mise en contact de la solution avec le substrat chargé des nanoparticules en quantité réduite se sont fixées de manière fortuite et non maîtrisée, sous la forme d'une structure résultante d'un bruit de dépôt ayant une répartition peu dense en terme de compacité, aléatoire et dépendante de l'échantillon du substrat électret sur lequel a été formé l'assemblage, Dans une première étape de repérage, la zone de surface est repérée par des coordonnées spatiales dans un référentiel attaché au substrat électret. Dans une deuxième étape, une image de la structure aléatoire des nanoparticules fixées dans la zone de surface choisie et formant une signature est captée. L'image captée est au choix une image topograhique AFM, une image par microscopie optique, ou une image de photoluminescence. L'image captée et les coordonnées spatiales de la zone de surface choisie sont sauvegardées dans une mémoire de stockage.

De manière générale, le matériau électret est un matériau compris dans l'ensemble formé par les poly-méthacrylates de méthyle (PMMA), les copolymères d'oléfines cycliques (CoC), les polyéthylènes téréphtalate (PET), les Polydiméthylsiloxanes (PDMS), les polypropylènes (PP), les polycarbonates (PC), les polystyrènes (PS), les polychlorures de vinyle (PVC), les polytétrafluoroéthylènes (PFTE), le sulfate de triglycine (TGS), le fluorure polyvinylidène (PVDF), le nitrure de silicium (Si₃N₄), l'oxyde de silicium (SiO₂), le composé Si₃N₄/SiO₂/Si (NOS).

De manière générale, les nanoparticules colloïdales sont des composés stabilisés par eux-mêmes ou par des ligands et/ou des charges, ayant des propriétés physiques comprises dans l'ensemble formé par les propriétés plasmoniques, conductrices, magnétiques, luminescentes, catalytiques, électrochromiques, photochromiques rendus sensiblement neutres et polarisables électriquement, réalisés à partir de nanoparticules colloïdales de base.

Les nanoparticules colloïdales de base possèdent un coeur solide et le cas échéant une coquille, et sont comprises dans l'ensemble formé par le latex, SiO₂, TiO₂, ZrO₂ ; CdS, CdSe, PbSe, GaAs, GaN, InP, In₂O₃, ZnS, ZnO, MoS₂, Si, C, ITO ,Fe₂O₃, Fe₃O₄, Co, Fe-Co, Fe₃C, Fe₅C₂, Ni ; Au, Ag, Cu, Pt, et les nanoparticules bi-métalliques ; WO₃ ; NaLnF₄, les fluorures de lanthanide (LnF₃), les oxydes de lanthanides (Ln₂O₃), les zirconates, silicates, hydroxydes (Ln(OH)₃) et les sulfures d'oxydes dopés ou non avec un ou plusieurs lanthanides différents (Ln désignant un lanthanide), les mélanges de ces composés.

Lorsque le milieu dispersant est un solvant liquide non polarisant, le solvant est compris dans l'ensemble formé par le pentane, l'iso-pentane, l'hexane, l'heptane, l'octane, le nonane, le décane, le cyclopentane, le cyclohexane, le cycloheptane, le cyclooctane, le cyclohéxène, le benzène, le toluène, le méthylcyclohexane, le xylène, le mésithylène, le chloroforme, le chlorure de méthylène, le tétrachloroéthylène.

Lorsque le milieu dispersant est un gaz dispersant non polarisant, le gaz dispersant est compris dans l'ensemble formé par le diazote N₂, l'argon Ar, et l'air.

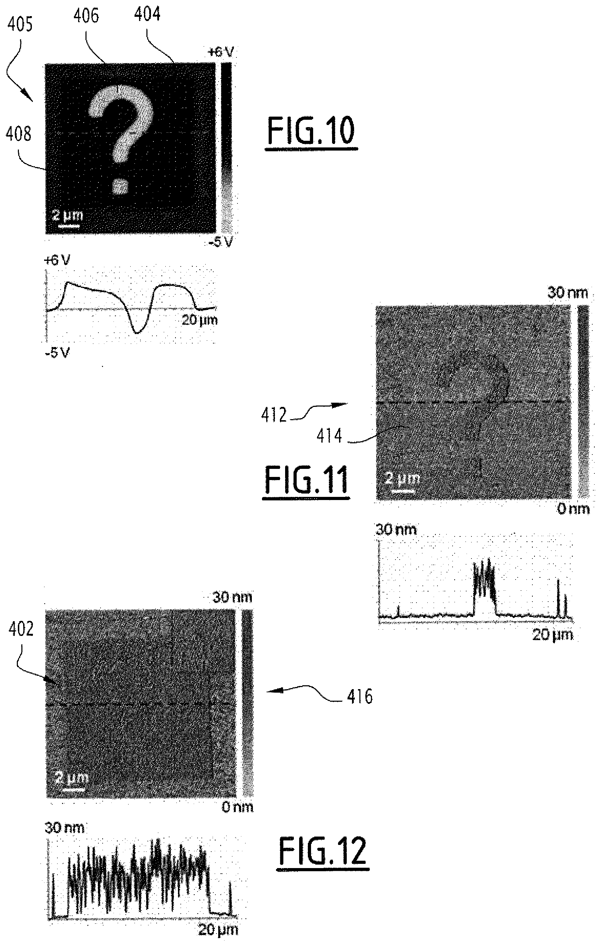

Suivant les Figures 10, 11 et 12, l'inscription de charges par AFM peut également être utilisée pour réaliser des assemblages binaires de nanoparticules colloïdales avec un placement commandé et contrôlé de manière précise de deux types de nanoparticules colloïdales. Ce type d'assemblage binaire offre un degré élevé de sécurité pour des marques de traçabilité et anti-contrefaçon.

Suivant les Figures 10, 11, et 12, un assemblage binaire 402 a été fabriqué en utilisant un motif de charges 404 comportant à la fois des charges positives et des charges négatives, et des dispersions de nanoparticules à base de β-NaYF₄, différentes par leurs charges électriques, leurs degrés de polarisabilité, leurs concentrations et leurs bandes d'émission de conversion haute. L'assemblage binaire fabriqué 402 permet ainsi d'obtenir un micro motif codé en couleurs.

Suivant la Figure 10, une image KFM 405 du potentiel de surface du micro motif 404 de charges, utilisé pour créer l'assemblage binaire 402, est fournie.

Le micro motif de charges 404 utilisé pour créer l'assemblage binaire consiste en une marque 406, ayant la forme d'un point d'interrogation chargé négativement de 1,5 µm de largeur, en contraste avec un fond carré 408, chargé positivement de 15 µm de côté. Le micro motif 404 a été développé en utilisant successivement deux dispersions différentes de nanocristaux colloïdaux (i) une première dispersion d'un premier type de nanoparticules, des nanocristaux coeur/coquille β-NaYF4:Gd³⁺,Er³⁺, Yb³⁺/NaYF₄, de conversion haute en lumière verte, chargées positivement et dispersées dans de l'eau, et (ii) une deuxième dispersion d'un deuxième type de nanoparticules, des nanocristaux coeur/coquille de β-NaYF₄:Gd³⁺,Tm³⁺,Yb³⁺/NaYF₄, de conversion haute en lumière bleue, quasi neutres électriquement et dispersées dans de l'hexane. Les deux types de nanocristaux ont ici des tailles similaires et les deux types de nanoparticules colloïdales peuvent être pompés optiquement par une même source d'excitation optique en raison du fait que les deux types de nanoparticules contiennent Yb³⁺ en tant qu'agent de transfert d'énergie.

Suivant la Figure 11, une image topographique AFM 412 du motif de charges développé d'abord à un premier stade 414 en utilisant la première dispersion aqueuse montre les nanoparticules du premier type chargés positivement, déposées de manière sélective selon une monocouche sur la marque du point d'interrogation 406 chargé négativement en tant que motif de charge.

Après le séchage sous azote et enlèvement des traces du solvant de la première dispersion, le motif de charges est développé à un deuxième stade en utilisant la deuxième dispersion ayant l'hexane pour solvant. Pendant ce deuxième stade du développement, les nanoparticules du deuxième type, c'est-à-dire les nanoparticules de conversion haute dans la lumière bleue, sont déposées sélectivement suivant une monocouche, sur le fond 408, chargé positivement du substrat électret et formant une partie du motif de charges. Cette sélectivité provient du fait que le potentiel de surface du motif 406 correspondant au point d'interrogation recouvert de la monocouche des nanoparticules du premier type, est insuffisant pour permettre un deuxième dépôt par et une fixation des nanoparticules du deuxième type, possédant une concentration adaptée à cet effet.

Il est à remarquer que le potentiel de surface du fond chargé positivement a été réglé finement par l'écriture de charges en AFM pour obtenir une densité de nanoparticules colloïdales du deuxième type, similaire voire identique à celle des nanoparticules de premier type déposées et fixées par force de Coulomb sur la marque du point d'interrogation. Ainsi, la marque du point d'interrogation ne peut pas être perçue topographiquement et distinguée du fond par microscope optique.

Suivant la Figure 12, l'analyse de l'image topographique 416 par AFM de l'assemblage final 402 ne permet pas de détecter les frontières de la marque du point d'interrogation par rapport au fond. Ainsi, l'information encodée dans le motif 402 est effectivement cachée ou fondue dans le fond.

Cette information encodée peut être ultérieurement retrouvée au travers d'une imagerie par luminescence.

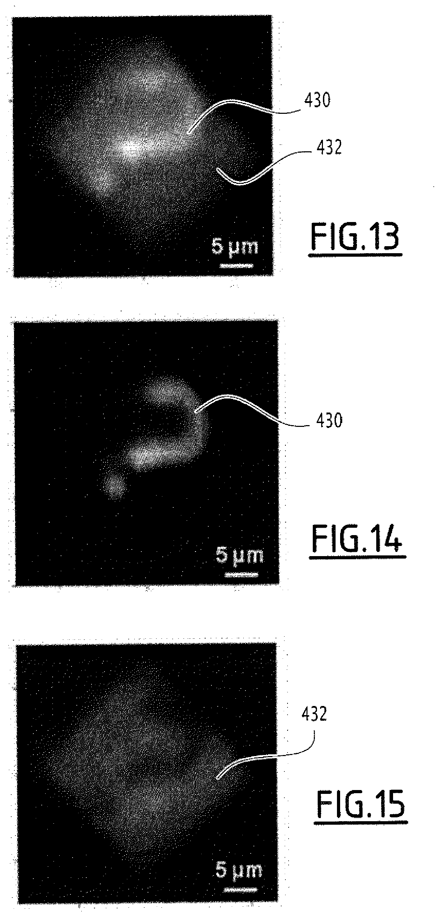

Suivant la Figure 13, lorsque la marque développée 430 du point d'interrogation est observée dans le visible sans filtrage en étant excitée par une diode laser dans le proche infrarouge NIR (en anglais Near Infrared Radiation) de 980 nm de longueur d'onde, la marque développée 430 apparaît plus brillante que le fond développé 432, en raison d'un rendement plus élevé de la conversion haute par les nanocristaux β-NaYF₄:Gd³⁺, Er³⁺,Yb³⁺/NaYF₄, de premier type (processus à deux photons) que le rendement de la conversion haute par les nanocristaux β-NaYF₄:Gd³⁺,Tm³⁺,Yb³⁺/NaYF₄, du deuxième type (processus à trois photons).

Suivant les Figures 14 et 15, les émissions des nanocristaux de deux types peuvent être effectivement séparées en utilisant des filtres dans le visible appropriés pour révéler les couleurs encodées dans le motif de l'assemblage binaire, respectivement un filtre sélectif du bleu (correspondant à une longueur d'onde de 485 nm) et un filtre sélectif du vert (correspondant à une longueur d'onde de 550 nm).

De manière générale et suivant un premier mode de réalisation de la Figure 16, un procédé 502 de fabrication d'une micro/nano structure binaire, formée de deux types de nanoparticules colloïdales, comprend un ensemble d'étapes 504, 506, 508, 510 et 512, exécutées successivement.

La micro/nano structure binaire formée de deux types de nanoparticules colloïdales comprend un premier assemblage monocouche de nanoparticules colloïdales du premier type, fixées sur un substrat électret, et ayant une première forme géométrique, librement choisie et prédéterminée, et un deuxième ensemble monocouche ou multicouches de nanoparticules colloïdales du deuxième type, fixées sur un substrat électret, et ayant une deuxième forme géométrique, librement choisie et prédéterminée, et dont au moins la première couche est compacte en termes d'absence de lacunes non souhaitées de tailles supérieures ou égales à la taille de deux nanoparticules adjacentes.

Dans une première étape 504, il est fourni un substrat électret, constitué en un matériau électret et ayant une surface libre de réception.

Puis, dans une deuxième étape 506, un potentiel électrique de surface est inscrit séquentiellement ou en parallèle sur la surface de réception du substrat électret suivant un motif prédéterminé de charges électriques ayant un premier signe et de charges électriques ayant un deuxième signe opposé au premier. Le motif de charges est composé d'un premier sous motif de charges de premier signe, correspondant au premier assemblage monocouche de nanoparticules de premier type, et d'un deuxième sous motif de charges de deuxième signe, correspondant au deuxième assemblage monocouche ou multicouches de nanoparticules de deuxième type.

Ensuite, dans une troisième étape 508, le substrat électret, ayant la surface de réception inscrite par le potentiel de surface, est mis en contact avec une première dispersion colloïdale pendant une première durée de mise en contact.

La première dispersion colloïdale comporte des nanoparticules du premier type chargées électriquement selon le deuxième signe et un premier milieu dispersant sous la forme d'un solvant liquide ou d'un gaz.

La première durée de mise en contact est suffisamment longue pour laisser se former sur le premier sous-motif de charges inscrit dans le substrat électret le premier assemblage monocouche de nanoparticules du premier type liées au substrat sous l'action de forces électrophorétiques, créées à partir de l'interaction Coulombienne entre les nanoparticules de premier type et le potentiel de surface du premier sous-motif de charges, jusqu'à ce que la première forme géométrique souhaitée du premier ensemble soit obtenue.

Puis, dans une quatrième étape 510, le substrat électret et le premier assemblage, formant ensemble une micro structure intermédiaire de fin de troisième étape sont séchés en enlevant le premier solvant.

Ensuite, dans une cinquième étape 512, la structure intermédiaire séchée est mise en contact dans une deuxième dispersion colloïdale pendant une deuxième durée de mise en contact.

La deuxième dispersion colloïdale comporte des nanoparticules colloïdales du deuxième type, neutres ou quasi-neutres électriquement et électriquement polarisables sous l'action d'un champ électrique externe, et un deuxième milieu de dispersion, sous la forme d'un solvant liquide ou d'un gaz, sensiblement dépourvu d'action de polarisation électrique, dans lequel les nanoparticules colloïdales de deuxième type sont dispersées.

La valeur absolue du potentiel électrique de surface et la concentration en nano particules de deuxième type sont respectivement supérieures ou égales à un premier seuil de potentiel électrique de surface et à un deuxième seuil de concentration, les premier et deuxième seuils dépendant chacun de la nature du deuxième solvant et de la nature des nanoparticules de deuxième type polarisables, de sorte qu'après la deuxième durée de mise en contact suffisamment longue et inférieure à une 15 minutes, le deuxième assemblage obtenu est le deuxième assemblage monocouche ou multicouches ayant la deuxième forme géométrique souhaitée et dont au moins la première couche est compacte en termes d'absence de lacunes non souhaitées de tailles supérieures ou égales à la taille de deux nanoparticules adjacentes, les nanoparticules étant liées entre elles et/ou au substrat sous l'action de forces diélectrophorétiques créées à partir de l'interaction entre les nanoparticules polarisables et le potentiel de surface du deuxième sous motif.

Lorsqu'un procédé d'inscription séquentielle de charges électriques de polarités différentes sur le substrat électret est exécuté au cours de la deuxième étape, il est compris dans l'ensemble formé par une inscription de charges électriques par un faisceau d'ions focalisés, une inscription de charges électriques par un faisceau d'électrons focalisés, une inscription de charges électriques par microscopie à force atomique (AFM), et une inscription de charges électriques par électrophotographie (dénommée encore xérographie).

Lorsque le procédé d'inscription en parallèle de charges de polarités différentes sur le substrat électret est exécuté au cours de la deuxième étape, il est compris dans l'ensemble formé par la nano impression électrique, le microcontact électrique..

Dans tous les cas, il est possible d'effectuer deux injections successives avec des polarisations électriques différentes.

il est à remarquer que l'inscription séquentielle par nanoxérographie AFM permet avantageusement d'inscrire en une seule étape ininterrompue ou en une seule passe un motif de charges comportant à la fois des charges positives et des charges négatives.

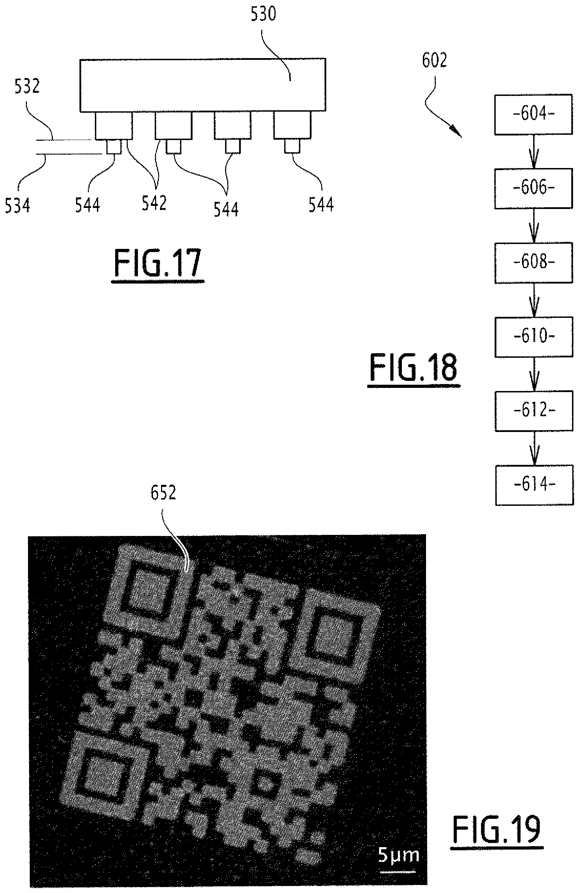

En variante, il est possible de mettre en oeuvre une inscription parallèle par micro contact électrique qui utilise un seul timbre. Dans ce cas, un timbre souple à deux niveaux, comme par exemple un timbre 530 en matériau élastomère, est représenté dans la Figure 17, est utilisé. Le timbre 530 en élastomère comprend deux niveaux de motifs 532, 534, un premier 532 et un deuxième 534, dont les première et deuxième surfaces associées 542, 544 sont conductrices et connectées électriquement entre elles pour former des surfaces équipotentielles. Les première et deuxième surfaces associées 542, 544 correspondent respectivement au premier sous-motif et au deuxième sous-motif de charges.

Les première et deuxième surfaces 542, 542 sont configurées pour être des surfaces équipotentielles soit en métallisant l'intégralité de la surface inférieure du timbre, les flancs de jonctions des première et deuxième surfaces 542, 542 inclus, soit en utilisant un timbre conducteur en volume.

Lorsque une inscription en parallèle de charges différentes et opposées est mise en oeuvre, d'abord le timbre est appliqué sur l'électret avec une première force F1 suffisante pour écraser le deuxième niveau 534 du timbre élastomère, et mettre en contact à la fois la première surface 542 et la deuxième surface 544 sur l'électret, et une injection de charges est effectuée avec une tension V1.

Ensuite, par relâchement, le timbre est appliqué sur l'électret avec une deuxième force F2 d'intensité plus faible de sorte que seul le deuxième niveau du timbre élastomère, c'est-à-dire seule la deuxième surface 544 soit en contact avec l'électret, et une injection de charges est effectuée avec une deuxième tension V2 de polarité opposée à celle de la première tension V1 pendant une durée suffisante pour annuler les charges inscrites sous la tension V1 et inscrire ensuite les charges du deuxième motif.

De manière générale et suivant un deuxième mode de réalisation de la Figure 18, un procédé 602 de fabrication d'une micro/nano structure binaire, formée de deux types de nanoparticules colloïdales comprend un ensemble d'étapes 604, 606, 608, 610, 612, 614, exécutées successivement.

Dans une première étape 604, il est fourni un substrat électret, constitué en un matériau électret et ayant une surface libre de réception plane.

Puis, dans une deuxième étape 606, un premier potentiel électrique de surface est inscrit séquentiellement ou en parallèle sur la surface de réception du substrat électret suivant un premier sous-motif prédéterminé de charges électriques ayant un premier signe, correspondant à un premier ensemble monocouche ou multicouches de nanoparticules du premier type, le premier sous-motif composant une première partie d'un motif de charges qui comporte également un deuxième sous-motif prédéterminé de charges électriques ayant un deuxième signe opposé au premier signe.

Ensuite, dans une troisième étape 608, le substrat électret, ayant la surface de réception inscrite par le premier potentiel de surface, est mis en contact avec une première dispersion colloïdale pendant une première durée de mise en contact.

La première dispersion colloïdale comporte des nanoparticules du premier type soit chargées électriquement selon le deuxième signe, soit sensiblement neutres et polarisable électriquement, et un premier milieu dispersant sous la forme d'un solvant liquide ou d'un gaz.

La première durée de mise en contact est suffisamment longue pour laisser se former sur le premier sous-motif de charges inscrit dans le substrat électret, le premier assemblage monocouche de nanoparticules du premier type avec la première forme géométrique souhaitée. Les nanoparticules du premier ensemble sont liées au substrat soit sous l'action de forces électrophorétiques, créées à partir de l'interaction Coulombienne entre les nanoparticules de premier type et le potentiel de surface du premier sous-motif de charges lorsque des nanoparticules du premier type sont chargées électriquement selon le deuxième signe , soit sous l'action de forces diélectrophorétiques créées à partir de l'interaction entre les nanoparticules polarisables et le potentiel de surface du premier sous-motif de charges, jusqu'à ce que la première forme géométrique souhaitée du premier ensemble soit obtenue.

Puis, dans une quatrième étape 610, le substrat électret et le premier assemblage, formant ensemble une micro/nano structure intermédiaire de fin de troisième étape, sont séchés.

Dans une cinquième étape 612 suivante, un deuxième potentiel électrique de surface est inscrit séquentiellement ou en parallèle sur la surface de réception du substrat électret de la structure intermédiaire séchée et en dehors des zones recouvertes par le premier assemblage, suivant le deuxième sous-motif prédéterminé de charges électriques ayant le deuxième signe.

Puis, dans une sixième étape 614, la structure intermédiaire inscrite par le deuxième potentiel de surface est mise en contact dans une deuxième dispersion colloïdale pendant une deuxième durée de mise en contact.

La deuxième dispersion colloïdale comporte des nanoparticules colloïdales du deuxième type, neutres ou quasi-neutres, et électriquement polarisables sous l'action d'un champ électrique externe, et un deuxième milieu de dispersion, sous la forme d'un solvant liquide ou d'un gaz, sensiblement dépourvu d'action de polarisation électrique dans lequel les nanoparticules colloïdales sont dispersées.

La valeur absolue du potentiel électrique de surface et la concentration en nanoparticules de deuxième type sont respectivement supérieures ou égales à un premier seuil de potentiel électrique de surface et à un deuxième seuil de concentration, les premier et deuxième seuils dépendant chacun de la nature du deuxième milieu de dispersion et de la nature des nanoparticules de deuxième type polarisables, de sorte qu'après la deuxième durée de mise en contact suffisamment longue et inférieure à 15 minutes, le deuxième assemblage obtenu est le deuxième ensemble monocouche ou multicouches ayant la deuxième forme géométrique souhaitée et dont au moins la première couche est compacte en termes d'absence de lacunes non souhaitées de tailles supérieures à la taille de deux nanoparticules adjacentes, les nanoparticules étant liées entre elles et/ou au substrat sous l'action de forces diélectrophorétiques créées à partir de l'interaction entre les nanoparticules polarisables et le potentiel de surface du deuxième sous-motif.

Le procédé d'inscription séquentielle de charges électriques de même signe sur le substrat électret, exécuté au cours de la deuxième étape 606 ou la cinquième étape 612, est compris dans l'ensemble formé par une inscription de charges électriques par un faisceau d'ions focalisés, une inscription de charges électriques par un faisceau d'électrons focalisés et une inscription de charges électriques par microscopie à force atomique (AFM) et une inscription de charges électriques par électrophotographie (dénommée encore xérographie)..

Le procédé d'inscription en parallèle de charges de même signe sur le substrat électret est compris dans l'ensemble formé par la nano impression électrique, le microcontact électrique.

En particulier, les nanoparticules colloïdales du premier type possèdent la propriété de convertir un rayonnement dans un spectre proche de l'infrarouge (NIR) en un rayonnement dans un premier spectre du visible, et les nanoparticules du deuxième type possèdent la propriété de convertir un rayonnement dans le spectre proche de l'infrarouge (NIR) en un rayonnement dans un deuxième spectre du visible, le premier spectre du visible étant différent du deuxième spectre du visible.

En particulier, la concentration en nanoparticules chargées du premier type, le premier solvant, les nanoparticules du premier type en termes de taille, le premier sous-motif de charge, la première durée de mise en contact, la concentration en nanoparticules polarisables du deuxième type, le deuxième solvant, les nanoparticules du deuxième type en termes de taille et de polarisabilité, et la deuxième durée de mise en contact sont choisis pour obtenir le premier assemblage monocouche ayant la première forme géométrique et le deuxième assemblage ayant la deuxième forme géométrique souhaitée, les première et deuxième formes géométriques étant des formes conjuguées et ayant une même hauteur par rapport à la surface de réception du substrat, de sorte que la forme géométrique du deuxième ensemble est indétectable par microscopie AFM ou par une microscopie optique utilisant un éclairement dans le spectre du visible.

De manière générale et indépendamment du procédé mis en oeuvre pour le réaliser, une microstructure formée de nanoparticules colloïdales comprend un substrat électret et un assemblage de nanoparticules colloïdales,

Le substrat électret, constitué en un matériau électret et ayant une surface libre de réception, est inscrit sur sa surface de réception par un potentiel électrique de surface suivant un motif prédéterminé de charges électriques positives et/ou négatives.

L'assemblage de nanoparticules colloïdales fixées sur le substrat électret possède une forme géométrique, librement choisie et prédéterminée.

Les nanoparticules colloïdales sont neutres ou quasi-neutres électriquement, et électriquement polarisables sous l'action d'un champ électrique externe.

Les nanoparticules colloïdales polarisables sont disposées en monocouche ou en multicouches en étant liées directement entre elles et/ou au substrat sous l'action de forces diélectrophorétiques, créées par l'interaction existant entre les nanoparticules polarisables et le potentiel de surface du motif de charge.

Le motif de charges électriques de même signe inscrit dans le substrat électret correspond à la forme géométrique de l'ensemble de nanoparticules monocouche ou multicouches.

La valeur absolue du potentiel électrique de surface créé par le motif de charges est supérieure ou égale à un premier seuil de potentiel électrique de surface qui dépend de la nature des nanoparticules polarisables, et telle qu'au moins la première couche de l'assemblage de nanoparticules colloïdales est compacte en termes d'absence de lacunes non souhaitées de tailles supérieures ou égales à la taille de deux nanoparticules adjacentes, de préférence à la taille d'une nanoparticule.

En variante, la valeur absolue du potentiel électrique de surface créé par le motif de charges est supérieure ou égale à un troisième seuil qui dépend de la nature des nanoparticules polarisables, et tel que l'assemblage de nanoparticules colloïdales est multicouches.

En variante, la microstructure est formée de nanoparticules colloïdales de deux types différents et comprend sous la forme d'un assemblage binaire un substrat électret, un premier assemblage monocouche ou multicouches de nanoparticules colloïdales du premier type, et un deuxième assemblage monocouche ou multicouches de nanoparticules colloïdales du deuxième type.

Le substrat électret est constitué en un matériau électret et possède une surface libre de réception.

Les nanoparticules colloïdales du premier type formant le premier assemblage sont déposées sur le substrat électret.

Les nanoparticules colloïdales du deuxième type formant le deuxième assemblage sont déposées sur le substrat électret.

Le substrat électret comporte un potentiel électrique de surface inscrit sur la surface de réception du substrat électret suivant un motif prédéterminé de charges électriques ayant un premier signe et ayant un deuxième signe opposé au premier, le motif de charges étant composé d'un premier sous motif de charges du premier signe et d'un deuxième sous motif de charges de deuxième signe opposé.

Les nanoparticules du premier type formant le premier assemblage monocouche sont soit chargées électriquement selon le deuxième signe et liées au substrat électret sous l'action de forces Coulombiennes créées par l'interaction existant entre les nanoparticules de premier type et le potentiel de surface du premier sous-motif de charges inscrit dans le substrat électret, soit sensiblement neutres et polarisables électriquement et liées au substrat électrique sous l'action de forces diélectrophorétiques créées à partir de l'interaction entre les nanoparticules polarisables et le potentiel de surface du premier sous-motif de charges.

Les nanoparticules colloïdales du deuxième type formant le deuxième assemblage monocouche ou multicouches, sont neutres ou quasi-neutres électriquement et électriquement polarisables sous l'action d'un champ électrique externe.

Les nanoparticules colloïdales du deuxième type sont liées entre elles et/ou au substrat sous l'action de forces diéelectrophorétiques, créées à partir de l'interaction existant entre les nanoparticules de deuxième type, électriquement neutres et polarisables, et le potentiel de surface du deuxième sous-motif de charges inscrit dans le substrat électret.

Le deuxième sous-motif de charges électriques de deuxième signe, inscrit dans le substrat électret, correspond à la forme géométrique du deuxième assemblage, monocouche ou multicouches, de nanoparticules.

La valeur absolue du potentiel électrique de surface créé par le deuxième sous motif de charges est supérieure ou égale à un premier seuil de potentiel électrique de surface qui dépend de la nature des nanoparticules polarisables, et tel qu'au moins la première couche du deuxième assemblage de nanoparticules colloïdales est compacte en termes d'absence de lacunes non souhaitées de tailles supérieures ou égales à la taille de deux nanoparticules adjacentes, de préférence à la taille d'une particule.

En variante, les nanoparticules chargées du premier type et les nanoparticules neutres polarisables du deuxième type ont respectivement une première taille et une deuxième taille.

Le premier assemblage et le deuxième assemblage possèdent respectivement un premier nombre et un deuxième nombre de couches, et le produit du premier nombre de couches par la première taille est sensiblement égal au produit du deuxième nombre de couches par la deuxième taille.

Les formes des premier et deuxième sous-motifs de tension en termes de codage d'intensité et de signe du potentiel sur la surface de réception du substrat électret sont configurées de sorte que les première et deuxième formes géométriques respectivement du premier assemblage et du deuxième assemblage sont des formes conjuguées entre elles et ont sensiblement une même hauteur par rapport à la surface de réception du substrat électret, rendant ainsi la forme géométrique du deuxième assemblage indétectable par AFM ou par une microscopie optique utilisant un éclairement dans spectre du visible.

En variante, les nanoparticules du premier type possèdent la propriété de convertir un rayonnement dans un spectre proche de l'infrarouge (NIR) en un rayonnement dans un premier spectre du visible, et les nanoparticules du deuxième type possèdent la propriété de convertir un rayonnement dans le spectre proche de l'infrarouge (NIR) en un rayonnement dans un deuxième spectre du visible, le premier spectre du visible étant différent du deuxième spectre du visible.

De manière générale, le matériau électret est un matériau compris dans l'ensemble formé par les polyméthacrylates de méthyle (PMMA), les copolymères d'oléfines cycliques (CoC), les polyéthylènes téréphtalate (PET), les Polydiméthylsiloxanes (PDMS), les polypropylènes (PP), les polycarbonates (PC), les polystyrènes (PS), les polychlorures de vinyle (PVC), les polytétrafluoroéthylènes (PFTE), le sulfate de triglycine (TGS), le fluorure polyvinylidène (PVDF), le nitrure d silicium (Si₃N₄), l'oxyde de silicium (SiO₂), le composé Si₃N₄/SiO₂/Si (NOS).

De manière générale, les nanoparticules colloïdales sont des composés stabilisés par eux-mêmes ou par des ligands et/ou des charges, ayant des propriétés physiques comprises dans l'ensemble formé par les propriétés plasmoniques, conductrices, magnétiques, luminescentes, catalytiques, électrochromiques, photochromiques rendus sensiblement neutres et polarisables électriquement, réalisés à partir de nanoparticules colloïdales de base.

Les nanoparticules colloïdales de base possèdent un coeur solide et le cas échéant une coquille, et sont comprises dans l'ensemble formé par le latex, SiO₂, TiO₂, ZrO₂ ; CdS, CdSe, PbSe, GaAs, GaN, InP, In₂O₃, ZnS, ZnO, MoS₂, Si, C, ITO ,Fe₂O₃, Fe₃O₄, Co, Fe-Co, Fe₃C, Fe₅C₂, Ni ; Au, Ag, Cu, Pt, et les nanoparticules bi-métalliques ; WO₃ ; NaLnF₄, les fluorures de lanthanide (LnF₃), les oxydes de lanthanides (Ln₂O₃), les zirconates, silicates, hydroxydes (Ln(OH)₃) et les sulfures d'oxydes dopés ou non avec un ou plusieurs lanthanides différents (Ln désignant un lanthanide), les mélanges de ces composés.Lorsque le milieu dispersant est un solvant liquide non polarisant, le solvant est compris dans l'ensemble formé par le pentane, l'isopentane, l'hexane, l'heptane, l'octane, le nonane, le décane, le cyclopentane, le cyclohexane, le cycloheptane, le cyclooctane, le cyclohéxène, le benzène, le toluène, le méthylcyclohexane, le xylène, le mésithylène, le chloroforme, le chlorure de méthylène, le tétrachloroéthylène.

Lorsque le milieu dispersant est un gaz dispersant non polarisant, le gaz dispersant est compris dans l'ensemble formé par le diazote N₂, l'argon Ar, et l'air.

De manière particulière, des microstructures de nanoparticules colloïdales sont des assemblages compacts mono et multicouches de nanocristaux β-NaYF₄ de conversion optique haute, serrées au plus près, fixés sur de films électrets en PMMA et de 100 nm d'épaisseur. Le nombre de couches de nanocristaux déposés est réglé avec finesse par le potentiel de surface des motifs de charge inscrits dans les films électret en PMMA et la concentration en nanocristaux dans la dispersion.

La formation d'assemblages multicouches de nanocristaux exige des motifs de charges à potentiel de surface élevé, des concentrations élevées de nanocristaux élevés et un solvant de dispersion électriquement non polarisant. Les nanocristaux doivent être électriquement polarisables à un degré élevé et neutres en terme électrostatique.

Des assemblages binaires de nanocristaux sont créés en utilisant un substrat électret sur lequel des motifs de charges positives et négatives ont été inscrits et en immergeant le substrat inscrit dans des dispersions de nanocristaux, par exemple β-NaYF₄, de charges électriques différentes et de luminescence en conversion haute de spectres différents. Les propriétés de luminescence en conversion haute des assemblages de nanocristaux sont bien corrélées avec leur géométrie et leur composition.

Toutes ces caractéristiques permettent la fabrication de micro/nano motifs de nanocristaux encodés en termes de (i) géométrie, (ii) de type de nanocristaux, (iii) d'intensité de luminescence, (iv) de couleur d'émission par l'utilisation de deux types de nanocristaux à conversion haute.

De plus, les assemblages codés en terme de couleurs peuvent être rendus non discernables en termes de topographie, cachant ainsi l'information de manière efficace.

La rapidité et l'efficacité économique des procédés décrits ci-dessus, la capacité à écrire des motifs quelconques de forme géométrique souhaitée, et la maîtrise du contrôle de l'architecture spatiale de l'assemblage dans les trois directions, désignés par exemple par des axes notés X, Y, et Z permettent de construire des micro/nano structures uniques de formes complexes, codées en termes de couleurs et d'intensités, qui peuvent être utilisées comme des étiquettes d'anti-contrefaçon et/ou de traçabilité et/ou d'authentification ayant un niveau de sécurité élevé.

Les étiquettes anti-contrefaçon et/ou de traçabilité et/ou d'authentification peuvent présenter divers niveaux de sécurité, lesdits niveaux de sécurité pouvant ou non se cumuler. Ces niveaux de sécurité peuvent être :
- la taille micro/nano des structures, qui rend les structure « invisibles » à l'oeil et impossible à trouver avec un microscope si leur emplacement exact n'est pas connu ;
- la luminescence, sachant qu'en présence d'assemblages binaires ou d'assemblages de plus de deux types de nanoparticules la micro/nano structure peut présenter au moins deux longueurs d'onde d'émission différentes ;
- l'intensité de luminescence, cette dernière pouvant présenter des variations pour une même micro/nano structure, ces variations étant dues à des hauteurs d'assemblages différentes au sein de la même micro/nano structure ;
- le dépôt aléatoire de nanoparticules sur une zone de surface du substrat électret, hors assemblage, ce dépôt présentant une signature unique propre à chaque micro/nano structure ;
- le masquage d'un assemblage de nanoparticules par un ou plusieurs autres assemblages de nanoparticules, le masquage étant obtenu avec des assemblages binaires ou des assemblages de plus de deux types de nanoparticules non discernables en termes de topographie, cachant ainsi l'information de manière efficace. Ledit masquage rend l'identification de l'information impossible topographiquement, seule une lecture en luminescence permettant de révéler l'information.

Les étiquettes anti-contrefaçon et/ou de traçabilité et/ou d'authentification, présentant un ou plusieurs niveaux de sécurité, encode, en sus, l'information topographiquement, la micro/nano structure présentant une géométrie particulière.

Suivant la Figure 19, une étiquette anti-contrefaçon et/ou de traçabilité et/ou d'authentification est par exemple un QR code tridimensionnel détectable en fluorescence par microscopie optique. Les nanoparticules colloïdales sont ici des particules de latex de 100 nm de diamètre.

En variante, le deuxième mode de réalisation du procédé 602 décrit à la Figure 18 peut être généralisé par la mise en oeuvre d'une séquence selon un ordre prédéterminé d'un nombre entier, supérieur ou égal à deux, de paires d'étapes, chaque paire d'étapes étant associée à un ordre ou un rang k d'emplacement dans la séquence, à un type prédéterminé de nanoparticules sensiblement neutres et polarisables à déposer dépendant du rang k, et à une géométrie de dépôt prédéterminé dépendante du rang k.

Chaque paire d'étapes, caractérisée par son rang k, est la succession d'une première d'étape d'inscription de rang k d'un motif de charges dépendant du type prédéterminé de particules à déposer et de la géométrie de dépôt associée fonction du rang k et d'une deuxième étape de dépôt des nanoparticules ayant le type associé au rang k sur le motif de charges inscrit pendant la première étape associé au rang k.

Ainsi peuvent être obtenus notamment des assemblages tridimensionnels ternaires de nanoparticules à compacité élevée, et des assemblages à nombre plus élevé encore de types de nanoparticules différentes.

En variante, une étiquette anti-contrefaçon et/ou de traçabilité et/ou d'authentification comprenant une micro/nano structure de nanoparticules colloïdales telle que définie ci-dessus ou obtenue par le procédé défini ci-dessus comprend en outre :
- une structure de nanoparticules fixées de manière fortuite et non maîtrisée suivant un bruit de dépôt, ayant une répartition peu dense en terme de compacité et aléatoire, réalisée sur une zone de surface du substrat électret non recouverte par l'assemblage, et repérée sur le substrat électret par des coordonnées spatiales, et
- une image de ladite structure aléatoire de nanoparticules déposées sur la zone de surface repérée, l'image captée étant au choix une image topograhique AFM, une image optique, ou une image de photoluminescence, et étant sauvegardée dans une mémoire.

Les coordonnées de l'image de ladite structure aléatoire sont sauvegardées sur un support d'information en correspondance de l'image de ladite structure aléatoire. Le support d'information est par exemple le même support d'enregistrement que celui de l'image. Il peut être également un support d'enregistrement différent. Dans tous les cas un lien informationnel d'affectation, par exemple informatique, existe entre l'image de la structure aléatoire et ses coordonnées spatiales.

## Revendications

1. Procédé de fabrication d'une micro/nano structure formée de nanoparticules colloïdales comprenant un assemblage monocouche ou multicouches de nanoparticules colloïdales fixées sur un substrat électret, ayant une forme géométrique, librement choisie et prédéterminée, comprenant les étapes consistant à :
dans une première étape (302), fournir un substrat électret, constitué en un matériau électret et ayant une surface libre de réception, puis
dans une deuxième étape (4 ; 304), inscrire un potentiel électrique de surface sur la surface de réception du substrat électret suivant un motif prédéterminé de charges électriques positives et/ou négatives correspondant à l'assemblage monocouche ou multicouches de nanoparticules, puis
dans une troisième étape (6 ; 306), mettre en contact le substrat électret ayant la surface de réception inscrite par le potentiel de surface suivant le motif souhaité de charges électriques, avec une dispersion colloïdale pendant une durée de mise en contact suffisamment longue et inférieure ou égale à quinze minutes,
dans lequel la dispersion colloïdale comporte des nanoparticules colloïdales sensiblement neutres et polarisables électriquement sous l'action d'un champ électrique externe, et un milieu de dispersion, sous la forme d'un solvant liquide ou d'un gaz, sensiblement dépourvu d'action de polarisation électrique, dans lequel les nanoparticules colloïdales sont dispersées, **caractérisé en ce que**
la valeur absolue du potentiel électrique de surface et la concentration en nanoparticules polarisables sont respectivement supérieures ou égales à un premier seuil de potentiel électrique de surface et à un deuxième seuil de concentration, les premier et deuxième seuils dépendant chacun de la nature du milieu de dispersion et de la nature des nanoparticules polarisables, de sorte que
après la première durée de mise en contact, la micro/nano structure obtenue est une micro/nano structure monocouche ou multicouches ayant la forme géométrique souhaitée et dont au moins la première couche est compacte en termes d'absence de lacunes non souhaitées de tailles supérieures ou égales à la taille de deux nanoparticules adjacentes, de préférence à la taille d'une nanoparticule, les nanoparticules étant liées entre elles et/ou au substrat sous l'action de forces diélectrophorétiques, créées à partir de l'interaction entre les nanoparticules polarisables et le potentiel de surface inscrit.

2. Procédé de fabrication d'une micro/nano structure de nanoparticules colloïdales selon la revendication 1, dans lequel
l'assemblage de nanoparticules colloïdales fixées sur le substrat électret, ayant une forme géométrique, librement choisie et prédéterminée est un assemblage multicouches dont au moins la première couche est compacte, et
la valeur absolue du potentiel électrique de surface et la concentration en nanoparticules polarisables sont respectivement supérieures ou égales à un troisième seuil de potentiel électrique de surface et à un quatrième seuil de concentration, les troisième et quatrième seuils dépendant chacun de la nature du milieu dispersant et de la nature des nanoparticules polarisables, de sorte que
après la durée de mise en contact, la micro/nano structure obtenue est la micro/nano structure multicouches ayant la forme géométrique souhaitée, dont au moins la première couche est compacte en termes d'absence de lacunes non souhaitées de tailles supérieures ou égales à la taille de deux nanoparticules adjacentes, de préférence à la taille d'une nanoparticule, les nanoparticules étant liées entre elles et/ou au substrat sous l'action de forces diélectrophorétiques créées à partir de l'interaction entre les nanoparticules neutres et polarisables électriquement et le potentiel de surface inscrit.

3. Procédé de fabrication d'une micro/nano structure de nanoparticules colloïdales selon la revendication 1, dans lequel
l'assemblage de nanoparticules colloïdales fixées sur un substrat électret, ayant une forme géométrique, librement choisie et prédéterminée est un assemblage multicouches d'un certain nombre Nc de couches dont chacune des couches est compacte en termes d'absence de lacunes non souhaitées de tailles supérieures à la taille de deux nanoparticules adjacentes, de préférence à la taille d'une nanoparticule, et
la valeur absolue du potentiel électrique de surface et la concentration en nanoparticules polarisables sont respectivement supérieures ou égales à un cinquième seuil de potentiel électrique de surface et à un sixième seuil de concentration, les cinquième et sixième seuils dépendant chacun de la nature du milieu de dispersion, la nature des nanoparticules polarisables et du nombre de couches, de sorte que
après la durée de mise en contact, la micro/nano structure obtenue est la micro/nano structure multicouches ayant la forme géométrique souhaitée, dont toutes les couches sont compactes en termes d'absence de lacunes non souhaitées de taille supérieures ou égales à la taille de deux nanoparticules adjacentes, de préférence à la taille d'une nanoparticule, les nanoparticules étant liées entre elles et/ou au substrat sous l'action de forces diélectrophorétiques créées à partir de l'interaction entre les nanoparticules polarisables et le potentiel de surface inscrit.

4. Procédé de fabrication d'une micro/nano structure binaire formée de deux types de nanoparticules colloïdales comprenant
un premier assemblage monocouche de nanoparticules colloïdales du premier type, fixées sur un substrat électret, et ayant une première forme géométrique, librement choisie et prédéterminée, et
un deuxième assemblage monocouche ou multicouches de nanoparticules colloïdales du deuxième type, fixées sur un substrat électret, et ayant une deuxième forme géométrique, librement choisie et prédéterminée, le procédé comprenant
les étapes consistant à :
dans une première étape (504), fournir un substrat électret, constitué en un matériau électret et ayant une surface libre de réception, puis
dans une deuxième étape (506), inscrire séquentiellement ou en parallèle un potentiel électrique de surface sur la surface de réception du substrat électret suivant un motif prédéterminé de charges électriques ayant un premier signe et de charges électriques ayant un deuxième signe opposé au premier, le motif de charges étant composé d'un premier sous motif de charges du premier signe, correspondant au premier assemblage monocouche de nanoparticules de premier type, et d'un deuxième sous motif de charges du deuxième signe, correspondant au deuxième assemblage monocouche ou multicouches de nanoparticules de deuxième type,
dans une troisième étape (508), mettre en contact le substrat électret ayant la surface de réception inscrite par le potentiel de surface, avec une première dispersion colloïdale pendant une première durée de mise en contact,
la première dispersion colloïdale comportant des nanoparticules du premier type chargées électriquement selon le deuxième signe et un premier milieu de dispersion sous la forme d'un solvant liquide ou d'un gaz, et la première durée de mise en contact étant suffisamment longue pour laisser se former sur le premier sous-motif de charges inscrit dans le substrat électret le premier assemblage monocouche, ayant la première forme géométrique souhaitée, de nanoparticules du premier type liées au substrat sous l'action de forces électrophorétiques, créées à partir de l'interaction Coulombienne entre les nanoparticules de premier type et le potentiel de surface du premier sous-motif de charges, puis
dans une quatrième étape (510), sécher le substrat électret et le premier assemblage, formant ensemble une micro/nano structure intermédiaire de fin de troisième étape, en enlevant le premier milieu de dispersion, puis
dans une cinquième étape (512), mettre en contact la structure intermédiaire séchée avec une deuxième dispersion colloïdale pendant une deuxième durée de mise en contact,
la deuxième dispersion colloïdale comportant des nanoparticules colloïdales du deuxième type, sensiblement neutres et polarisables électriquement sous l'action d'un champ électrique externe, et un deuxième milieu de dispersion sous la forme d'un solvant liquide ou d'un gaz, sensiblement dépourvu d'action de polarisation électrique, dans lequel les nanoparticules colloïdales de deuxième type sont dispersées, et
la valeur absolue du potentiel électrique de surface et la concentration en nanoparticules de deuxième type étant respectivement supérieures ou égales à un premier seuil de potentiel électrique de surface et à un deuxième seuil de concentration, les premier et deuxième seuils dépendant chacun de la nature du deuxième milieu de dispersion et de la nature des nanoparticules de deuxième type polarisables, de sorte que
après la deuxième durée de mise en contact suffisamment longue et inférieure à 15 minutes, le deuxième assemblage obtenu est le deuxième assemblage monocouche ou multicouches ayant la deuxième forme géométrique souhaitée et dont au moins la première couche est compacte en termes d'absence de lacunes non souhaitées de taille supérieures ou égales à la taille de deux nanoparticules adjacentes, de préférence à la taille d'une nanoparticule, les nanoparticules étant liées entre elles et/ou au substrat sous l'action de forces diélectrophorétiques créées à partir de l'interaction entre les nanoparticules polarisables et le potentiel de surface du deuxième sous-motif.

5. Procédé de fabrication d'une micro/nano structure binaire formée de deux types de nanoparticules colloïdales comprenant
un premier assemblage monocouche ou multicouches de nanoparticules colloïdales du premier type, fixées sur un substrat électret, et ayant une première forme géométrique, librement choisie et prédéterminée, et
un deuxième assemblage monocouche ou multicouches de nanoparticules colloïdales du deuxième type, fixées sur un substrat électret, et ayant une deuxième forme géométrique, librement choisie et prédéterminée, le procédé comprenantles étapes consistant à :
dans une première étape (604), fournir un substrat électret, constitué en un matériau électret et ayant une surface libre de réception, puis
dans une deuxième étape (606), inscrire séquentiellement ou en parallèle un premier potentiel électrique de surface sur la surface de réception du substrat électret suivant un premier sous-motif prédéterminé de charges électriques ayant un premier signe, correspondant au premier ensemble de nanoparticules du premier type, le premier sous-motif composant une première partie d'un motif de charge qui comporte également un deuxième sous-motif prédéterminé de charges électriques ayant un deuxième signe opposé au premier signe,
dans une troisième étape (608), mettre en contact le substrat électret ayant la surface de réception inscrite par le premier potentiel de surface, avec une première dispersion colloïdale pendant une première durée de mise en contact inférieure ou égale à 15 minutes,
la première dispersion colloïdale comportant des nanoparticules du premier type soit chargées électriquement selon le deuxiéme signe, soit sensiblement neutres et polarisables électriquement, et un premier milieu de dispersion sous la forme d'un solvant liquide ou d'un gaz, et la première durée de mise en contact étant suffisamment longue pour laisser se former sur le premier sous-motif de charges inscrit dans le substrat électret le premier ensemble ayant la première forme géométrique monocouche ou multicouches de nanoparticules du premier type liées au substrat, soit sous l'action de forces électrophorétiques, créées à partir de l'interaction Coulombienne entre les nanoparticules de premier type et le potentiel de surface du premier sous-motif de charges lorsque des nanoparticules du premier type sont chargées électriquement selon le deuxième signe, soit sous l'action de forces diélectrophorétiques créées à partir de l'interaction entre les nanoparticules polarisables et le potentiel de surface du premier sous-motif de charges lorsque les nanoparticules du premier type sont sensiblement neutres et polarisables électriquement,
dans une quatrième étape (610), sécher le substrat électret et le premier ensemble, formant ensemble une micro/nano structure intermédiaire de fin de troisième étape (608), puis
dans une cinquième étape (612), inscrire séquentiellement ou en parallèle un deuxième potentiel électrique de surface sur la surface de réception du substrat électret de la structure intermédiaire séchée et en dehors des zones recouvertes par le premier ensemble, suivant le deuxième sous-motif prédéterminé de charges électriques ayant le deuxième signe, puis
dans une sixième étape (614), mettre en contact la structure intermédiaire inscrite par le deuxième potentiel de surface avec une deuxième dispersion colloïdale pendant une deuxième durée de mise en contact,
la deuxième dispersion colloïdale comportant des nanoparticules colloïdales du deuxième type, neutres ou quasi-neutres électriquement et électriquement polarisables sous l'action d'un champ électrique externe, et un deuxième milieu dispersant, sous la forme d'un solvant liquide ou d'un gaz, sensiblement dépourvu d'action de polarisation électrique dans lequel les nanoparticules colloïdales sont dispersées, et
la valeur du potentiel électrique de surface et la concentration en nanoparticules de deuxième type étant respectivement supérieures ou égales à un premier seuil de potentiel électrique de surface et à un deuxième seuil de concentration, les premier et deuxième seuils dépendant chacun de la nature du deuxième milieu de dispersion et de la nature des nanoparticules de deuxième type polarisables, de sorte que
après la deuxième durée de mise en contact, le deuxième assemblage obtenu est le deuxième ensemble monocouche ou multicouches ayant la deuxième forme géométrique souhaitée et dont au moins la première couche est compacte en termes d'absence de lacunes non souhaitées de taille supérieure ou égales à la taille de deux nanoparticules adjacentes du deuxième type, de préférence à la taille d'une nanoparticule du deuxième type, les nanoparticules étant liées entre elles et/ou au substrat sous l'action de forces diélectrophorétiques créées à partir de l'interaction entre les nanoparticules polarisables et le potentiel de surface du deuxième sous-motif.

6. Procédé de fabrication d'une microstructure binaire de nanoparticules colloïdales selon la revendication 4 ou la revendication 5, dans lequel les nanoparticules colloïdales du premier type possèdent la propriété de convertir un rayonnement dans un spectre proche de l'infrarouge (NIR) en un rayonnement dans un premier spectre du visible, et les nanoparticules du deuxième type portent possèdent la propriété de convertir le même rayonnement dans le spectre proche de l'infrarouge (NIR) en un rayonnement dans un deuxième spectre du visible, le premier spectre du visible étant différent du deuxième spectre du visible.

7. Procédé de fabrication d'une micro/nano structure binaire de nanoparticules colloïdales selon l'une quelconques des revendication 4 à 6, dans lequel la concentration en nanoparticules chargées du premier type, le premier milieu de dispersion, les nanoparticules du premier type en termes de taille, le premier sous-motif de charges, la première durée de mise en contact, la concentration en nanoparticules polarisables du deuxième type, le deuxième milieu de dispersion, les nanoparticules du deuxième type en termes de taille et de polarisabilité, et la deuxième durée de mise en contact sont choisis pour obtenir le premier assemblage ayant la première forme géométrique et le deuxième assemblage ayant la deuxième forme géométrique souhaitée, les première et deuxième formes géométrique étant des formes conjuguées et ayant une même hauteur par rapport à la surface de réception du substrat, de sorte que la forme géométrique du premier ensemble et la forme géométrique du deuxième ensemble séparé sont indétectables topographiquement par AFM ou par une microscopie optique utilisant un éclairement dans spectre du visible.

8. Procédé de fabrication d'une micro/nano structure de nanoparticules colloïdales selon l'une quelconque des revendications 1 à 7, dans lequel l'étape d'inscription du potentiel électrique de surface sur la surface de réception du substrat électret suivant un motif de charges est réalisé au choix,
par un procédé d'inscription séquentielle de charges positives et/ou négatives sur le substrat électret compris dans l'ensemble formé par une inscription de charges électriques par un faisceau d'ions focalisés, une inscription de charges électriques par un faisceau d'électrons focalisés, une inscription de charges électriques par microscopie à force atomique (AFM) et une inscription de charges électriques par électrophotographie,
par un procédé d'inscription en parallèle de charges positives et/ou négatives sur le substrat électret compris dans l'ensemble formé par la nano impression électrique et le microcontact électrique.

9. Procédé de fabrication d'une micro/nano structure de nanoparticules colloïdales selon l'une quelconque des revendications 1 à 8, dans lequel
le matériau électret est un matériau compris dans l'ensemble formé par les poly-méthacrylates de méthyle (PMMA), les copolymères d'oléfines cycliques (CoC), les polyéthylènes téré-phtalate (PET), les Polydiméthylsiloxanes (PDMS), les polypropylènes (PP), les polycarbonates (PC), les polystyrènes (PS), les polychlorures de vinyle (PVC), les polytétrafluoroéthylènes (PFTE), le sulfate de triglycine (TGS), le fluorure polyvinylidène (PVDF), le nitrure d silicium (Si₃N₄), l'oxyde de silicium (SiO₂), le composé Si₃N₄/SiO₂/Si (NOS) ;
les nanoparticules colloïdales sensiblement neutres et polarisables électriquement sont des composés stabilisés par eux-mêmes ou par des ligands et/ou des charges, ayant des propriétés physiques comprises dans l'ensemble formé par les propriétés plasmoniques, conductrices, magnétiques, luminescentes, catalytiques, électrochromiques, photochromiques rendus sensiblement neutres et polarisables électriquement, réalisés à partir de nano particules colloïdales de base,
les nanoparticules colloïdales de base possédant un coeur solide et le cas échéant une coquille, et étant comprises dans l'ensemble formé par le latex, SiO₂, TiO₂, ZrO₂; CdS, CdSe, PbSe, GaAs, GaN, InP, In₂O₃, ZnS, ZnO, MoS₂, Si, C, ITO, Fe₂O₃, Fe₃O₄, Co, Fe-Co, Fe₃C, Fe₅C₂, Ni ; Au, Ag, Cu, Pt, et les nanoparticules bi-métalliques ; WO₃; NaLnF₄, les fluorures de lanthanide (LnF₃), les oxydes de lanthanides (Ln₂O₃), les zirconates, silicates, hydroxydes (Ln(OH)₃) et les sulfures d'oxydes dopés ou non avec un ou plusieurs lanthanides différents (Ln désignant un lanthanide), les mélanges de ces composés.et le milieu dispersant des nanoparticules polarisables est au choix un solvant liquide ou un gaz non polarisant,
le solvant liquide étant compris dans l'ensemble formé par le pentane, l'isopentane, l'hexane, l'heptane, l'octane, le nonane, le décane, le cyclopentane, le cyclohexane, le cycloheptane, le cyclooctane, le cyclohéxène, le benzène, le toluène, le méthylcyclohexane, le xylène, le mésithylène, le chloroforme, le chlorure de méthylène, le tétrachloroéthylène,
le gaz dispersant non polarisant étant compris dans l'ensemble formé par le diazote N₂, l'argon Ar, et l'air.

10. Procédé de fabrication d'une micro/nano structure de nanoparticules colloïdales selon l'une quelconque des revendications 1 à 9, comprenant les étapes supplémentaires consistant à :
choisir et repérer par des coordonnées spatiales sur le substrat électret où l'assemblage a été formé une zone de surface non recouverte par l'assemblage sur laquelle des nanoparticules se sont fixées de manière fortuite et non maîtrisée, sous la forme d'une structure résultante d'un bruit de dépôt, ayant une répartition peu dense en terme de compacité, aléatoire et dépendante de l'échantillon du substrat électret sur lequel a été formé l'assemblage, puis
capter une image de la structure aléatoire des nanoparticules déposées dans la zone de surface choisie et formant une signature, l'image captée étant au choix une image topograhique AFM, une image optique, ou une image de photoluminescence, puis
sauvegarder dans une mémoire l'image captée et les coordonnées spatiales de la zone de surface correspondante.

11. Micro/nano structure formée de nanoparticules colloïdales comprenant
un substrat électret constitué en un matériau électret et ayant une surface libre de réception dans lequel est inscrit un potentiel électrique de surface sur la surface de réception du substrat électret suivant un motif de charges électriques positives et/ou négatives,
un assemblage de nanoparticules colloïdales fixées sur le substrat électret, ayant une forme géométrique,
dans lequel
les nanoparticules colloïdales sont sensiblement neutres et polarisables électriquement sous l'action d'un champ électrique externe, et
les nanoparticules polarisables sont disposées en monocouche ou multicouches en étant liées directement entre elles et/ou au substrat sous l'action de forces diélectrophorétiques, créées par l'interaction existant entre les nanoparticules polarisables et le potentiel de surface du motif de charge, et
le motif de charges électriques de même polarité inscrit dans le substrat électret correspond à la forme géométrique de l'ensemble de nanoparticules monocouche ou multicouches, **caractérisé en ce que**
la valeur absolue du potentiel électrique de surface créé par le motif de charges est supérieure ou égale à un premier seuil de potentiel électrique de surface qui dépend de la nature des nanoparticules polarisables, et tel qu'au moins la première couche de l'ensemble de nanoparticules colloïdales est compacte en termes d'absence de lacunes non souhaitées de taille supérieure à la taille de deux nanoparticules adjacentes, de préférence à la taille d'une nanoparticule.

12. Micro/nano structure formée de nanoparticules colloïdales selon la revendication 11, dans laquelle
la valeur absolue du potentiel électrique de surface créé par le motif de charges est supérieure ou égale à un troisième seuil qui dépend de la nature des nanoparticules polarisables, et tel que l'assemblage est multicouches.

13. Micro/nano structure formée de nanoparticules colloïdales de deux types différents comprenant sous la forme d'un assemblage binaire
un substrat électret constitué en un matériau électret et ayant une surface libre de réception,
un premier assemblage monocouche ou multicouches de nanoparticules colloïdales du premier type, fixées sur le substrat électret,
un deuxième assemblage monocouche ou multicouches de nanoparticules colloïdales du deuxième type, fixées sur le substrat électret,
**caractérisé en ce que**
le substrat électret comprend un potentiel électrique de surface inscrit sur la surface de réception du substrat électret suivant un motif prédéterminé de charges électriques ayant un premier signe et ayant un deuxième signe opposé au premier signe, le motif de charges étant composé d'un premier sous motif de charges de premier signe et d'un deuxième sous motif de charge de deuxième signe, et
les nanoparticules du premier type formant le premier ensemble monocouche ou multicouches sont soit chargées électriquement selon le deuxième signe et liées au substrat électret sous l'action de forces Coulombiennes créées par l'interaction existant entre les nanoparticules de premier type et le potentiel de surface du premier sous-motif de charges inscrit dans le substrat électret, soit sensiblement neutres et polarisables électriquement et liées entre elles et/ou au substrat sous l'action de forces diéelectrophorétiques créées à partir de l'interaction existant entre les nanoparticules de premier type et le potentiel de surface du premier sous-motif de charges inscrit dans le substrat électret, et
les nanoparticules colloïdales du deuxième type formant le deuxième ensemble monocouche ou multicouches, sont sensiblement neutres et polarisables électriquement sous l'action d'un champ électrique externe, sont liées entre elles et/ou au substrat sous l'action de forces diéelectrophorétiques créées à partir de l'interaction existant entre les nanoparticules de deuxième type et le potentiel de surface du deuxième sous-motif de charges inscrit dans le substrat électret, et
le deuxième sous motif de charges électriques de deuxième signe inscrit dans le substrat électret correspond à la forme géométrique du deuxième ensemble de nanoparticules monocouche ou multicouches, et
la valeur absolue du potentiel électrique de surface créé par le motif de charges est supérieure à un premier seuil de potentiel électrique de surface qui dépend de la nature des nanoparticules polarisables, et tel qu'au moins la première couche du deuxième ensemble de nanoparticules colloïdales est compacte en termes d'absence de lacunes non souhaitées de tailles supérieures ou égales à la taille de deux nano particules adjacentes, de préférence à la taille d'une nanoparticule.

14. Micro/nano structure formée de nanoparticules colloïdales de deux types différents selon la revendication 13 dans laquelle
les nanoparticules du premier type et les nanoparticules du deuxième type ont respectivement une première taille et une deuxième taille, et
les premier et deuxième ensembles possèdent respectivement un premier nombre et un deuxième nombre de couches, et
le produit du premier nombre de couches par la première taille et le produit du deuxième nombre de couches par la deuxième taille sont sensiblement égaux, et
les formes des premier et deuxième sous-motifs de tension en termes de codage d'intensité, de signe du potentiel sur la surface de réception du substrat électret sont configurées de sorte que les première et deuxième formes géométriques respectivement du premier ensemble et du deuxième ensemble sont des formes conjuguées et ont sensiblement une même hauteur par rapport à la surface de réception du substrat, rendant ainsi la forme géométrique du premier ensemble et la forme géométrique du deuxième ensemble indétectables séparément topographiquement par AFM et/ou par une microscopie optique utilisant un éclairement dans spectre du visible.

15. Micro/nano structure de nanoparticules colloïdales de deux types différents selon la revendication 13 ou 14 dans laquelle
les nanoparticules du premier type possèdent la propriété de convertir un rayonnement dans un spectre proche de l'infrarouge (NIR) en un rayonnement dans un premier spectre du visible, et les nanoparticules du deuxième type possèdent la propriété de convertir le même rayonnement dans le spectre proche de l'infrarouge (NIR) en un rayonnement dans un deuxième spectre du visible, le premier spectre du visible étant différent du deuxième spectre du visible.

16. Etiquette anti-contrefaçon et/ou de traçabilité et/ou d'authentification comprenant une micro/nano structure de nanoparticules colloïdales définie selon l'une quelconque des revendications 11 à 15 ou obtenue par le procédé définie selon l'une quelconque des revendications 1 à 10.

17. Etiquette anti-contrefaçon et/ou de traçabilité et/ou d'authentification selon la revendication 16, comprenant en outre
une structure de nanoparticules fixées de manière fortuite et non maîtrisée suivant un bruit de dépôt, ayant une répartition peu dense et terme de compacité et aléatoire, réalisée sur une zone de surface du substrat électret non recouverte par l'assemblage, et repérée sur le substrat électret par des coordonnées spatiales, et
une image de ladite structure aléatoire de nanoparticules déposées sur la zone de surface repérée, l'image captée étant au choix une image topographique AFM, une image optique, ou une image de photoluminescence, et étant sauvegardée dans une mémoire.

18. Etiquette anti-contrefaçon et/ou de traçabilité et/ou d'authentification selon la revendication 17, dans laquelle
les coordonnées de l'image de ladite structure aléatoire sont sauvegardées sur un support d'information en correspondance de l'image de ladite structure aléatoire.

## Patentansprüche

1. Verfahren zur Herstellung einer aus kolloidalen Nanopartikeln gebildeten Mikro-/Nanostruktur, die eine einschichtige oder mehrschichtige Anordnung von an einem Elektretsubstrat fixierten kolloidalen Nanopartikeln umfasst, die eine frei gewählte und vorbestimmte geometrische Form aufweist, umfassend die Schritte, die darin bestehen:
in einem ersten Schritt (302) ein Elektretsubstrat bereitzustellen, das aus einem Elektretmaterial besteht und eine freie Aufnahmefläche aufweist, anschließend
in einem zweiten Schritt (4; 304) ein elektrisches Oberflächenpotential auf die Aufnahmefläche des Elektretsubstrats zu prägen gemäß einem vorbestimmten Muster aus positiven und/oder negativen elektrischen Ladungen, das der einschichtigen oder mehrschichtigen Anordnung von Nanopartikeln entspricht, anschließend
in einem dritten Schritt (6; 306) das Elektretsubstrat, das die gemäß dem gewünschten elektrischen Ladungsmuster mit dem Oberflächenpotential geprägte Aufnahmefläche aufweist, mit einer kolloidalen Dispersion zu kontaktieren während einer Kontaktierungsdauer, die ausreichend lang und kleiner oder gleich fünfzehn Minuten ist,
wobei die kolloidale Dispersion kolloidale Nanopartikel, die im Wesentlichen neutral und unter der Wirkung eines äußeren elektrischen Feldes elektrisch polarisierbar sind, und ein Dispersionsmedium in der Form eines flüssigen Lösungsmittels oder eines Gases umfasst, das im Wesentlichen frei von elektrischer Polarisationswirkung ist, in welchem die kolloidalen Nanopartikel dispergiert sind, **dadurch gekennzeichnet, dass**
der Absolutwert des elektrischen Oberflächenpotentials und die Konzentration an polarisierbaren Nanopartikeln jeweils größer oder gleich einer ersten elektrischen Oberflächenpotentialschwelle und einer zweiten Konzentrationsschwelle sind, wobei die erste und zweite Schwelle jede von der Art des Dispersionsmediums und von der Art der polarisierbaren Nanopartikel abhängen, derart, dass
nach der ersten Kontaktierungsdauer die Mikro-/Nanostruktur, die erhalten wird, eine einschichtige oder mehrschichtige Mikro-/Nanostruktur ist, die die gewünschte geometrische Form aufweist und von der mindestens die erste Schicht kompakt ist, was das Fehlen von unerwünschten Lücken anbelangt, die von Größen größer oder gleich der Größe von zwei benachbarten Nanopartikeln, vorzugsweise der Größe eines Nanopartikels sind, wobei die Nanopartikel unter der Wirkung von dielektrophoretischen Kräften, die aus der Wechselwirkung zwischen den polarisierbaren Nanopartikeln und dem geprägten Oberflächenpotential erzeugt werden, aneinander und/oder an das Substrat gebunden sind.

2. Verfahren zur Herstellung einer Mikro-/Nanostruktur aus kolloidalen Nanopartikeln nach Anspruch 1, wobei
die Anordnung von am Elektretsubstrat fixierten kolloidalen Nanopartikeln, die eine frei gewählte und vorbestimmte geometrische Form aufweist, eine mehrschichtige Anordnung ist, von der mindestens die erste Schicht kompakt ist, und
der Absolutwert des elektrischen Oberflächenpotentials und die Konzentration an polarisierbaren Nanopartikeln jeweils größer oder gleich einer dritten elektrischen Oberflächenpotentialschwelle und einer vierten Konzentrationsschwelle sind, wobei die dritte und vierte Schwelle jede von der Art des dispergierenden Mediums und von der Art der polarisierbaren Nanopartikel abhängen, derart, dass
nach der Kontaktierungsdauer die Mikro-/Nanostruktur, die erhalten wird, die die gewünschte geometrische Form aufweisende mehrschichtige Mikro-/Nanostruktur ist, von der mindestens die erste Schicht kompakt ist, was das Fehlen von unerwünschten Lücken anbelangt, die von Größen größer oder gleich der Größe von zwei benachbarten Nanopartikeln, vorzugsweise der Größe eines Nanopartikels sind, wobei die Nanopartikel unter der Wirkung von dielektrophoretischen Kräften, die aus der Wechselwirkung zwischen den neutralen und elektrisch polarisierbaren Nanopartikeln und dem geprägten Oberflächenpotential erzeugt werden, aneinander und/oder an das Substrat gebunden sind.

3. Verfahren zur Herstellung einer Mikro-/Nanostruktur aus kolloidalen Nanopartikeln nach Anspruch 1, wobei
die Anordnung von an einem Elektretsubstrat fixierten kolloidalen Nanopartikeln, die eine frei gewählte und vorbestimmte geometrische Form aufweist, eine mehrschichtige Anordnung einer gewissen Anzahl Nc von Schichten ist, von der jede der Schichten kompakt ist, was das Fehlen von unerwünschten Lücken anbelangt, die von Größen größer als der Größe von zwei benachbarten Nanopartikeln, vorzugsweise der Größe eines Nanopartikels sind, und
der Absolutwert des elektrischen Oberflächenpotentials und die Konzentration an polarisierbaren Nanopartikeln jeweils größer oder gleich einer fünften elektrischen Oberflächenpotentialschwelle und einer sechsten Konzentrationsschwelle sind, wobei die fünfte und sechste Schwelle jede von der Art des Dispersionsmediums, der Art der polarisierbaren Nanopartikel und der Anzahl von Schichten abhängen, derart, dass
nach der Kontaktierungsdauer die Mikro-/Nanostruktur, die erhalten wird, die die gewünschte geometrische Form aufweisende mehrschichtige Mikro-/Nanostruktur ist, von der alle die Schichten kompakt sind, was das Fehlen von unerwünschten Lücken anbelangt, die einer Größe von größer oder gleich der Größe von zwei benachbarten Nanopartikeln, vorzugsweise der Größe eines Nanopartikels sind, wobei die Nanopartikel unter der Wirkung von dielektrophoretischen Kräften, die aus der Wechselwirkung zwischen den polarisierbaren Nanopartikeln und dem geprägten Oberflächenpotential erzeugt werden, aneinander und/oder an das Substrat gebunden sind.

4. Verfahren zur Herstellung einer binären Mikro-/Nanostruktur, die aus zwei Typen von kolloidalen Nanopartikeln gebildet ist, umfassend
eine erste einschichtige Anordnung von kolloidalen Nanopartikeln des ersten Typs, die an einem Elektretsubstrat fixiert sind, und die eine erste frei gewählte und vorbestimmte geometrische Form aufweist, und
eine zweite einschichtige oder mehrschichtige Anordnung von kolloidalen Nanopartikeln des zweiten Typs, die an einem Elektretsubstrat fixiert sind, und die eine zweite frei gewählte und vorbestimmte geometrische Form aufweist, wobei das Verfahren die Schritte umfasst, die darin bestehen:
in einem ersten Schritt (504) ein Elektretsubstrat bereitzustellen, das aus einem Elektretmaterial besteht und eine freie Aufnahmefläche aufweist, anschließend
in einem zweiten Schritt (506) sequentiell oder parallel ein elektrisches Oberflächenpotential auf die Aufnahmefläche des Elektretsubstrats zu prägen, gemäß einem vorbestimmten Muster aus elektrischen Ladungen, die ein erstes Vorzeichen aufweisen, und aus elektrischen Ladungen, die ein zweites, dem ersten entgegengesetztes Vorzeichen aufweisen, wobei das Ladungsmuster aus einem ersten Teilmuster aus Ladungen des ersten Vorzeichens, das der ersten einschichtigen Anordnung von Nanopartikeln des ersten Typs entspricht, und aus einem zweiten Teilmuster aus Ladungen des zweiten Vorzeichens, das der zweiten einschichtigen oder mehrschichtigen Anordnung von Nanopartikeln des zweiten Typs entspricht, zusammengesetzt ist,
in einem dritten Schritt (508) das Elektretsubstrat, das die mit dem Oberflächenpotential geprägte Aufnahmefläche aufweist, während einer ersten Kontaktierungsdauer mit einer ersten kolloidalen Dispersion zu kontaktieren,
wobei die erste kolloidale Dispersion Nanopartikel des ersten Typs, die elektrisch gemäß dem zweiten Vorzeichen geladen sind, und ein erstes Dispersionsmedium in der Form eines flüssigen Lösungsmittels oder eines Gases umfasst, und wobei die erste Kontaktierungsdauer ausreichend lang ist, um sich auf dem ersten Ladungsteilmuster, das in das Elektretsubstrat geprägt ist, die erste, die erste gewünschte geometrische Form aufweisende einschichtige Anordnung von Nanopartikeln des ersten Typs bilden zu lassen, die unter der Wirkung von elektrophoretischen Kräften, die aus der Coulombschen Wechselwirkung zwischen den Nanopartikeln des ersten Typs und dem Oberflächenpotential des ersten Ladungsteilmusters erzeugt werden, an das Substrat gebunden sind, anschließend
in einem vierten Schritt (510) das Elektretsubstrat und die erste Anordnung, die zusammen eine Mikro-/Nano-Zwischenstruktur des Endes des dritten Schritts bilden, unter Entfernen des ersten Dispersionsmediums zu trocknen, anschließend
in einem fünften Schritt (512) die getrocknete Zwischenstruktur während einer zweiten Kontaktierungsdauer mit einer zweiten kolloidalen Dispersion zu kontaktieren,
wobei die zweite kolloidale Dispersion kolloidale Nanopartikel des zweiten Typs, die im Wesentlichen neutral und unter der Wirkung eines äußeren elektrischen Feldes elektrisch polarisierbar sind, und ein zweites Dispersionsmedium in der Form eines flüssigen Lösungsmittels oder eines Gases umfasst, das im Wesentlichen frei von elektrischer Polarisationswirkung ist, in welchem die kolloidalen Nanopartikel des zweiten Typs dispergiert sind, und
der Absolutwert des elektrischen Oberflächenpotentials und die Konzentration an Nanopartikeln des zweiten Typs jeweils größer oder gleich einer ersten elektrischen Oberflächenpotentialschwelle und einer zweiten Konzentrationsschwelle sind, wobei die erste und zweite Schwelle jede von der Art des zweiten Dispersionsmediums und von der Art der polarisierbaren Nanopartikel des zweiten Typs abhängen, derart, dass
nach der zweiten Kontaktierungsdauer, die ausreichend lang und kleiner als 15 Minuten ist, die zweite Anordnung. die erhalten wird, die zweite einschichtige oder mehrschichtige Anordnung ist, die die zweite gewünschte geometrische Form aufweist und von der mindestens die erste Schicht kompakt ist, was das Fehlen von unerwünschten Lücken anbelangt, die einer Größe von größer oder gleich der Größe von zwei benachbarten Nanopartikeln, vorzugsweise der Größe eines Nanopartikels sind, wobei die Nanopartikel unter der Wirkung von dielektrophoretischen Kräften, die aus der Wechselwirkung zwischen den polarisierbaren Nanopartikeln und dem Oberflächenpotential des zweiten Teilmusters erzeugt werden, aneinander und/oder an das Substrat gebunden sind.

5. Verfahren zur Herstellung einer binären Mikro-/Nanostruktur, die aus zwei Typen von kolloidalen Nanopartikeln gebildet ist, umfassend
eine erste einschichtige oder mehrschichtige Anordnung von kolloidalen Nanopartikeln des ersten Typs, die an einem Elektretsubstrat fixiert sind, und die eine erste frei gewählte und vorbestimmte geometrische Form aufweist, und
eine zweite einschichtige oder mehrschichtige Anordnung von kolloidalen Nanopartikeln des zweiten Typs, die an einem Elektretsubstrat fixiert sind, und die eine zweite frei gewählte und vorbestimmte geometrische Form aufweist, wobei das Verfahren die Schritte umfasst, die darin bestehen:
in einem ersten Schritt (604) ein Elektretsubstrat bereitzustellen, das aus einem Elektretmaterial besteht und eine freie Aufnahmefläche aufweist, anschließend
in einem zweiten Schritt (606) sequentiell oder parallel ein erstes elektrisches Oberflächenpotential auf die Aufnahmefläche des Elektretsubstrats zu prägen, gemäß einem ersten vorbestimmten Teilmuster aus elektrischen Ladungen, die ein erstes Vorzeichen aufweisen, das der ersten Einheit von Nanopartikeln des ersten Typs entspricht, wobei das erste Teilmuster einen ersten Teil eines Ladungsmusters zusammensetzt, das ebenfalls ein zweites vorbestimmtes Teilmuster aus elektrischen Ladungen aufweist, die ein zweites, dem ersten Vorzeichen entgegengesetztes Vorzeichen aufweisen,
in einem dritten Schritt (608) das Elektretsubstrat, das die mit dem ersten Oberflächenpotential geprägte Aufnahmefläche aufweist, während einer ersten Kontaktierungsdauer von kleiner oder gleich 15 Minuten mit einer ersten kolloidalen Dispersion zu kontaktieren,
wobei die erste kolloidale Dispersion Nanopartikel des ersten Typs, die entweder gemäß dem zweiten Vorzeichen elektrisch geladen oder im Wesentlichen neutral und elektrisch polarisierbar sind, und ein erstes Dispersionsmedium in der Form eines flüssigen Lösungsmittels oder eines Gases umfasst, und wobei die erste Kontaktierungsdauer ausreichend lang ist, um sich auf dem ersten Ladungsteilmuster, das in das Elektretsubstrat geprägt ist, die erste, die erste geometrische Form aufweisende einschichtige oder mehrschichtige Einheit von an das Substrat gebundenen Nanopartikeln des ersten Typs bilden zu lassen, entweder unter der Wirkung von elektrophoretischen Kräften, die aus der Coulombschen Wechselwirkung zwischen den Nanopartikeln des ersten Typs und dem Oberflächenpotential des ersten Ladungsteilmusters erzeugt werden, wenn Nanopartikel des ersten Typs elektrisch gemäß dem zweiten Vorzeichen geladen sind, oder unter der Wirkung von dielektrophoretischen Kräften, die aus der Wechselwirkung zwischen den polarisierbaren Nanopartikeln und dem Oberflächenpotential des ersten Ladungsteilmusters erzeugt werden, wenn die Nanopartikel des ersten Typs im Wesentlichen neutral und elektrisch polarisierbar sind,
in einem vierten Schritt (610) das Elektretsubstrat und die erste Einheit, die zusammen eine Mikro-/Nano-Zwischenstruktur des Endes des dritten Schritts (608) bilden, zu trocknen, anschließend
in einem fünften Schritt (612) sequentiell oder parallel ein zweites elektrisches Oberflächenpotential auf die Aufnahmefläche des Elektretsubstrats der getrockneten Zwischenstruktur und außerhalb der Bereiche, die von der ersten Einheit bedeckt sind, zu prägen, gemäß dem zweiten vorbestimmten Teilmuster aus elektrischen Ladungen, die das zweite Vorzeichen aufweisen, anschließend
in einem sechsten Schritt (614) die Zwischenstruktur, die mit dem zweiten Oberflächenpotential geprägt ist, während einer zweiten Kontaktierungsdauer mit einer zweiten kolloidalen Dispersion zu kontaktieren,
wobei die zweite kolloidale Dispersion kolloidale Nanopartikel des zweiten Typs, die elektrisch neutral oder quasi-neutral und unter der Wirkung eines äußeren elektrischen Feldes elektrisch polarisierbar sind, und ein zweites dispergierendes Medium in der Form eines flüssigen Lösungsmittels oder eines Gases umfasst, das im Wesentlichen frei von elektrischer Polarisationswirkung ist, in welchem die kolloidalen Nanopartikel dispergiert sind, und
wobei der Wert des elektrischen Oberflächenpotentials und die Konzentration an Nanopartikeln des zweiten Typs jeweils größer oder gleich einer ersten elektrischen Oberflächenpotentialschwelle und einer zweiten Konzentrationsschwelle sind, wobei die erste und zweite Schwelle jede von der Art des zweiten Dispersionsmediums und von der Art der polarisierbaren Nanopartikel des zweiten Typs abhängen, derart, dass
nach der zweiten Kontaktierungsdauer die zweite Anordnung, die erhalten wird, die zweite einschichtige oder mehrschichtige Einheit ist, die die zweite gewünschte geometrische Form aufweist und von der mindestens die erste Schicht kompakt ist, was das Fehlen von unerwünschten Lücken anbelangt, die einer Größe von größer oder gleich der Größe von zwei benachbarten Nanopartikeln des zweiten Typs, vorzugsweise der Größe eines Nanopartikels des zweiten Typs sind, wobei die Nanopartikel unter der Wirkung von dielektrophoretischen Kräften, die aus der Wechselwirkung zwischen den polarisierbaren Nanopartikeln und dem Oberflächenpotential des zweiten Teilmusters erzeugt werden, aneinander und/oder an das Substrat gebunden sind.

6. Verfahren zur Herstellung einer binären Mikrostruktur aus kolloidalen Nanopartikeln nach Anspruch 4 oder Anspruch 5, wobei die kolloidalen Nanopartikel des ersten Typs die Eigenschaft besitzen, eine Strahlung in einem Nahinfrarotspektrum (NIR) in eine Strahlung in einem ersten Spektrum des Sichtbaren umzuwandeln, und die Nanopartikel des zweiten Typs die Eigenschaft besitzen, dieselbe Strahlung im Nahinfrarotspektrum (NIR) in eine Strahlung in einem zweiten Spektrum des Sichtbaren umzuwandeln, wobei sich das erste Spektrum des Sichtbaren vom zweiten Spektrum des Sichtbaren unterscheidet.

7. Verfahren zur Herstellung einer binären Mikro-/Nanostruktur aus kolloidalen Nanopartikeln nach einem der Ansprüche 4 bis 6, wobei die Konzentration an geladenen Nanopartikeln des ersten Typs, das erste Dispersionsmedium, die Nanopartikel des ersten Typs, was die Größe anbelangt, das erste Ladungsteilmuster, die erste Kontaktierungsdauer, die Konzentration an polarisierbaren Nanopartikeln des zweiten Typs, das zweite Dispersionsmedium, die Nanopartikel des zweiten Typs, was die Größe und Polarisierbarkeit anbelangt, und die zweite Kontaktierungsdauer so gewählt werden, dass die erste Anordnung, die die erste geometrische Form aufweist, und die zweite Anordnung, die die zweite gewünschte geometrische Form aufweist, erhalten werden, wobei die erste und zweite geometrische Form zusammenhängende Formen sind und in Bezug auf die Aufnahmefläche des Substrats ein und dieselbe Höhe aufweisen, derart, dass die geometrische Form der ersten Einheit und die geometrische Form der zweiten, getrennten Einheit durch AFM oder durch eine optische Mikroskopie, die eine Beleuchtung im Spektrum des Sichtbaren verwendet, topografisch nicht detektierbar sind.

8. Verfahren zur Herstellung einer Mikro-/Nanostruktur aus kolloidalen Nanopartikeln nach einem der Ansprüche 1 bis 7, wobei der Schritt des Prägens des elektrischen Oberflächenpotentials auf die Aufnahmefläche des Elektretsubstrats gemäß einem Ladungsmuster wahlweise ausgeführt wird
über ein Verfahren zum sequentiellen Prägen von positiven und/oder negativen Ladungen auf das Elektretsubstrat, das in der Einheit umfasst ist, die von einem Prägen von elektrischen Ladungen durch einen fokussierten lonenstrahl, einem Prägen von elektrischen Ladungen durch einen fokussierten Elektronenstrahl, einem Prägen von elektrischen Ladungen durch Rasterkraftmikroskopie (AFM) und einem Prägen von elektrischen Ladungen durch Elektrophotographie gebildet wird,
über ein Verfahren zum parallelen Prägen von positiven und/oder negativen Ladungen auf das Elektretsubstrat, das in der Einheit umfasst ist, die vom elektrischen Nanoimprint und dem elektrischen Mikrokontakt gebildet wird.

9. Verfahren zur Herstellung einer Mikro-/Nanostruktur aus kolloidalen Nanopartikeln nach einem der Ansprüche 1 bis 8, wobei
das Elektretmaterial ein Material ist, das in der Einheit enthalten ist, die von den Polymethylmethacrylaten (PMMA), den Cycloolefin-Copolymeren (CoC), den Polyethylenterephthalaten (PET), den Polydimethylsiloxanen (PDMS), den Polypropylenen (PP), den Polycarbonaten (PC), den Polystyrolen (PS), den Polyvinylchloriden (PVC), den Polytetrafluorethylenen (PFTE), Triglycinsulfat (TGS), Polyvinylidenfluorid (PVDF), Siliziumnitrid (Si₃N₄), Siliziumoxid (SiO₂), der Verbindung Si₃N₄/SiO₂/Si (NOS) gebildet wird;
die im Wesentlichen neutralen und elektrisch polarisierbaren kolloidalen Nanopartikel aus kolloidalen Basis-Nanopartikeln ausgeführte, im Wesentlichen neutral und elektrisch polarisierbar gemachte, durch sich selbst oder durch Liganden und/oder Ladungen stabilisierte Verbindungen sind, die physische Eigenschaften aufweisen, die in der Einheit enthalten sind, die von den plasmonischen, leitenden, magnetischen, lumineszierenden, katalytischen, elektrochromen, photochromen Eigenschaften gebildet wird,
wobei die kolloidalen Basis-Nanopartikel einen festen Kern und gegebenenfalls eine Hülle umfassen und in der Einheit enthalten sind, die von Latex, SiO₂, TiO₂, ZrO₂; CdS, CdSe, PbSe, GaAs, GaN, InP, In₂O₃, ZnS, ZnO, MoS₂, Si, C, ITO, Fe₂O₃, Fe₃O₄, Co, Fe-Co, Fe₃C, Fe₅C₂, Ni; Au, Ag, Cu, Pt, und den bimetallischen Nanopartikeln; WO₃; NaLnF₄, den Lanthanidfluoriden (LnF₃), den Lanthanidoxiden (Ln₂O₃), den Zirkonaten, Silikaten, Hydroxiden (Ln(OH)₃) und den Sulfiden von Oxiden, die mit einem oder mehreren verschiedenen Lanthaniden dotiert sind oder nicht (wobei Ln ein Lanthanid bezeichnet), den Mischungen dieser Verbindungen gebildet wird, und das dispergierende Medium der polarisierbaren Nanopartikel wahlweise ein flüssiges Lösungsmittel oder ein nicht polarisierendes Gas ist,
wobei das flüssige Lösungsmittel in der Einheit enthalten ist, die von Pentan, Isopentan, Hexan, Heptan, Octan, Nonan, Decan, Cyclepentan, Cyclohexan, Cycloheptan, Cyclooctan, Cyclohexen, Benzen, Toluol, Methylcyclohexan, Xylen, Mesithylen, Chloroform, Methylenchlorid, Tetrachlorethylen gebildet wird,
wobei das nicht polarisierende dispergierende Gas in der Einheit enthalten ist, die von Distickstoff N₂, Argon Ar, und Luft gebildet wird.

10. Verfahren zur Herstellung einer Mikro-/Nanostruktur aus kolloidalen Nanopartikeln nach einem der Ansprüche 1 bis 9, umfassend die zusätzlichen Schritte, die darin bestehen:
über räumliche Koordinaten auf dem Elektretsubstrat, auf dem die Anordnung gebildet wurde, einen nicht von der Anordnung bedeckten Oberflächenbereich zu suchen und ausfindig zu machen, auf dem sich Nanopartikel in zufälliger und unkontrollierter Weise in der Form einer aus einem Abscheiderauschen resultierenden Struktur fixiert haben, die eine, was die Kompaktheit anbelangt, wenig dichte, willkürliche und von der Probe des Elektretsubstrats, auf dem die Anordnung gebildet wurde, abhängende Wiederholung aufweist, anschließend
ein Bild von der willkürlichen Struktur der Nanopartikel zu erfassen, die in dem gewählten Oberflächenbereich abgeschieden sind und eine Signatur bilden, wobei das erfasste Bild wahlweise ein topographisches AFM-Bild, ein optisches Bild, oder ein Photolumineszenzbild ist, anschließend
das erfasste Bild und die räumlichen Koordinaten des entsprechenden Oberflächenbereichs in einem Speicher zu speichern.

11. Mikro-/Nanostruktur, die aus kolloidalen Nanopartikeln gebildet ist, umfassend
ein Elektretsubstrat, das aus einem Elektretmaterial besteht und eine freie Aufnahmefläche aufweist, wobei ein elektrisches Oberflächenpotential auf die Aufnahmefläche des Elektretsubstrats gemäß einem Muster aus positiven und/oder negativen elektrischen Ladungen geprägt ist,
eine Anordnung von auf dem Elektretsubstrat fixierten kolloidalen Nanopartikeln, die eine geometrische Form aufweist,
wobei
die kolloidalen Nanopartikel im Wesentlichen neutral und unter der Wirkung eines äußeren elektrischen Feldes elektrisch polarisierbar sind, und
die polarisierbaren Nanopartikel einschichtig oder mehrschichtig angeordnet sind, indem sie unter der Wirkung von dielektrophoretischen Kräften, die durch die zwischen den polarisierbaren Nanopartikeln und dem Oberflächenpotential des Ladungsmusters existierende Wechselwirkung erzeugt werden, direkt aneinander und/oder an das Substrat gebunden sind, und
das Muster aus elektrischen Ladungen derselben Polarität, das in das Elektretsubstrat geprägt ist, der geometrischen Form der einschichtigen oder mehrschichtigen Einheit von Nanopartikeln entspricht, **dadurch gekennzeichnet, dass**
der Absolutwert des elektrischen Oberflächenpotentials, das vom Ladungsmuster erzeugt wird, größer oder gleich einer ersten elektrischen Oberflächenpotentialschwelle ist, die von der Art der polarisierbaren Nanopartikel abhängt, und derart, dass mindestens die erste Schicht der Einheit von kolloidalen Nanopartikeln kompakt ist, was das Fehlen von unerwünschten Lücken einer Größe anbelangt, die größer als die Größe von zwei benachbarten Nanopartikeln, vorzugsweise als die Größe eines Nanopartikels ist.

12. Aus kolloidalen Nanopartikeln gebildete Mikro-/Nanostruktur nach Anspruch 11, wobei
der Absolutwert des elektrischen Oberflächenpotentials, das vom Ladungsmuster erzeugt wird, größer oder gleich einer dritten Schwelle ist, die von der Art der polarisierbaren Nanopartikel abhängt, und derart, dass die Anordnung mehrschichtig ist.

13. Mikro-/Nanostruktur, die aus kolloidalen Nanopartikeln zweier verschiedener Typen gebildet ist, umfassend, in der Form einer binären Anordnung
ein Elektretsubstrat, das aus einem Elektretmaterial besteht und eine freie Aufnahmefläche aufweist,
eine erste einschichtige oder mehrschichtige Anordnung von kolloidalen Nanopartikeln des ersten Typs, die auf dem Elektretsubstrat fixiert sind,
eine zweite einschichtige oder mehrschichtige Anordnung von kolloidalen Nanopartikeln des zweiten Typs, die auf dem Elektretsubstrat fixiert sind,
**dadurch gekennzeichnet, dass**
das Elektretsubstrat ein elektrisches Oberflächenpotential umfasst, das auf die Aufnahmefläche des Elektretsubstrats geprägt ist gemäß einem vorbestimmten Muster aus elektrischen Ladungen, die ein erstes Vorzeichen aufweisen, und die ein zweites, dem ersten Vorzeichen entgegengesetztes Vorzeichen aufweisen, wobei das Ladungsmuster aus einem ersten Teilmuster aus Ladungen des ersten Vorzeichens, und einem zweiten Teilmuster aus Ladungen des zweiten Vorzeichens zusammengesetzt ist, und
die Nanopartikel des ersten Typs, die die erste einschichtige oder mehrschichtige Einheit bilden, entweder gemäß dem zweiten Vorzeichen elektrisch geladen und unter der Wirkung von Coulombschen Kräften, die durch die Wechselwirkung erzeugt werden, welche zwischen den Nanopartikeln des ersten Typs und dem Oberflächenpotential des in das Elektretsubstrat geprägten ersten Ladungsteilmusters existiert, an das Elektretsubstrat gebunden sind, oder im Wesentlichen neutral und elektrisch polarisierbar und unter der Wirkung von dielektrophoretischen Kräften, die aus der Wechselwirkung erzeugt werden, welche zwischen den Nanopartikeln des ersten Typs und dem Oberflächenpotential des in das Elektretsubstrat geprägten ersten Ladungsteilmusters existiert, aneinander und/oder an das Substrat gebunden sind, und
die kolloidalen Nanopartikel des zweiten Typs, die die zweite einschichtige oder mehrschichtige Einheit bilden, im Wesentlichen neutral und unter der Wirkung eines äußeren elektrischen Feldes elektrisch polarisierbar sind, unter der Wirkung von dielektrophoretischen Kräften, die aus der Wechselwirkung erzeugt werden, welche zwischen den Nanopartikeln des zweiten Typs und dem Oberflächenpotential des in das Elektretsubstrat geprägten zweiten Ladungsteilmusters existiert, aneinander und/oder an das Substrat gebunden sind, und
das zweite Teilmuster aus elektrischen Ladungen des zweiten Vorzeichens, das in das Elektretsubstrat geprägt ist, der geometrischen Form der zweiten einschichtigen oder mehrschichtigen Einheit von Nanopartikeln entspricht, und
der Absolutwert des elektrischen Oberflächenpotentials, das vom Ladungsmuster erzeugt wird, größer als eine erste elektrische Oberflächenpotentialschwelle ist, die von der Art der polarisierbaren Nanopartikel abhängt, und derart, dass mindestens die erste Schicht der zweiten Einheit von kolloidalen Nanopartikeln kompakt ist, was das Fehlen von unerwünschten Lücken anbelangt, die von Größen größer oder gleich der Größe von zwei benachbarten Nanopartikeln, vorzugsweise der Größe eines Nanopartikels sind.

14. Aus kolloidalen Nanopartikeln zweier verschiedener Typen gebildete Mikro-/Nanostruktur nach Anspruch 13, wobei
die Nanopartikel des ersten Typs und die Nanopartikel des zweiten Typs jeweils eine erste Größe und eine zweite Größe aufweisen, und
die erste und zweite Einheit jeweils eine erste Anzahl und eine zweite Anzahl von Schichten besitzen, und
das Produkt aus der ersten Anzahl von Schichten mal der ersten Größe, und das Produkt aus der zweiten Anzahl von Schichten mal der zweiten Größe im Wesentlichen gleich sind, und
die Formen des ersten und zweiten Spannungsteilmusters, was die Intensitätscodierung, das Vorzeichen des Potentials auf der Aufnahmefläche des Elektretsubstrats anbelangt, derart konfiguriert sind, dass die erste und zweite geometrische Form jeweils der ersten Einheit und der zweiten Einheit zusammenhängende Formen sind und in Bezug auf die Aufnahmefläche des Substrats im Wesentlichen ein und dieselbe Höhe aufweisen, wodurch sie so die geometrische Form der ersten Einheit und die geometrische Form der zweiten Einheit durch AFM und/oder durch eine optische Mikroskopie, die eine Beleuchtung im Spektrum des Sichtbaren verwendet, topografisch nicht getrennt detektierbar machen.

15. Mikro-/Nanostruktur aus kolloidalen Nanopartikeln zweier verschiedener Typen nach Anspruch 13 oder 14, wobei
die Nanopartikel des ersten Typs die Eigenschaft besitzen, eine Strahlung in einem Nahinfrarotspektrum (NIR) in eine Strahlung in einem ersten Spektrum des Sichtbaren umzuwandeln, und die Nanopartikel des zweiten Typs die Eigenschaft besitzen, dieselbe Strahlung im Nahinfrarotspektrum (NIR) in eine Strahlung in einem zweiten Spektrum des Sichtbaren umzuwandeln, wobei sich das erste Spektrum des Sichtbaren vom zweiten Spektrum des Sichtbaren unterscheidet.

16. Fälschungssicherungs- und/oder Rückverfolgbarkeits- und/oder Authentifizierungsetikett, das eine Mikro-/Nanostruktur aus kolloidalen Nanopartikeln umfasst, die nach einem der Ansprüche 11 bis 15 definiert ist, oder über das Verfahren erhalten wird, das nach einem der Ansprüche 1 bis 10 definiert ist.

17. Fälschungssicherungs- und/oder Rückverfolgbarkeits- und/oder Authentifizierungsetikett nach Anspruch 16, weiter umfassend
eine Struktur aus Nanopartikeln, die in zufälliger und unkontrollierter Weise gemäß einem Abscheiderauschen fixiert sind, die eine, was die Kompaktheit anbelangt, wenig dichte und willkürliche Wiederholung aufweist, die auf einem Oberflächenbereich des Elektretsubstrats ausgeführt ist, der nicht von der Anordnung bedeckt ist, und auf dem Elektretsubstrat über räumliche Koordinaten ausfindig gemacht wird, und
ein Bild von der willkürlichen Struktur aus Nanopartikeln, die auf dem ausfindig gemachten Oberflächenbereich abgeschieden sind, wobei das erfasste Bild wahlweise ein topografisches AFM-Bild, ein optisches Bild oder ein Photolumineszenzbild ist und in einem Speicher gespeichert ist.

18. Fälschungssicherungs- und/oder Rückverfolgbarkeits- und/oder Authentifizierungsetikett nach Anspruch 17, wobei
die Koordinaten des Bildes der willkürlichen Struktur auf einem Informationsträger in Entsprechung mit dem Bild von der zufälligen Struktur gespeichert sind.

## Claims

1. A process for the manufacture of a micro/nanostructure formed of colloidal nanoparticles comprising a multilayer assembly of colloidal nanoparticles which are attached to an electret substrate, having a freely chosen and predetermined geometric shape, comprising the stages consisting in:
in a first stage (302), providing an electret substrate, composed of an electret material and having a free receiving surface, then
in a second stage (4; 304), writing a surface electric potential on the receiving surface of the electret substrate according to a predetermined pattern of positive and/or negative electric charges corresponding to the multilayer assembly of nanoparticles, then
in a third stage (6; 306), bringing the electret substrate having the receiving surface written with the surface potential according to the desired pattern of electric charges into contact with a colloidal dispersion for a contacting time which is sufficiently long and less than or equal to fifteen minutes,
wherein
the colloidal dispersion comprises electrically substantially neutral and polarizable electrically under the action of an external electric field and a dispersing medium, in the form of a liquid solvent or a gas which is substantially devoid of an electrical polarization action, in which the colloidal nanoparticles are dispersed, **characterized in that**
the absolute value of the surface electric potential and the concentration of polarizable nanoparticles are respectively greater than or equal to a first surface electric potential threshold and to a second concentration threshold, the first and second thresholds each depending on the nature of the dispersing medium and on the nature of the polarizable nanoparticles, so that
after the first contacting time, the micro/nanostructure obtained is a multilayer micro/nanostructure having the desired geometric shape, at least the first layer of which is compact in terms of absence of undesired gaps with sizes greater than or equal to the size of two adjacent nanoparticles, preferably greater than or equal to the size of one nanoparticle, the nanoparticles being bonded to one another and/or to the substrate under the action of dielectrophoretic forces created from the interaction between the polarizable nanoparticles and the written surface potential.

2. The process for the manufacture of a micro/nanostructure of colloidal nanoparticles as claimed in claim 1, in which:
the assembly of colloidal nanoparticles which are attached to the electret substrate, having a freely chosen and predetermined geometric shape, is a multilayer assembly, at least the first layer of which is compact, and
the absolute value of the surface electric potential and the concentration of polarizable nanoparticles are respectively greater than or equal to a third surface electric potential threshold and greater than or equal to a fourth concentration threshold, the third and fourth thresholds each depending on the nature of the dispersing medium and on the nature of the polarizable nanoparticles, so that
after the contacting time, the micro/nanostructure obtained is the multilayer micro/nanostructure having the desired geometric shape, at least the first layer of which is compact in terms of absence of undesired gaps with sizes of greater than or equal to the size of two adjacent nanoparticles, preferably with sizes greater than or equal to the size of one nanoparticle, the nanoparticles being bonded to one another and/or to the substrate under the action of dielectrophoretic forces created from the interaction between the neutral and electrically polarizable nanoparticles and the written surface potential.

3. The process for the manufacture of a micro/nanostructure of colloidal nanoparticles as claimed in claim 1, in which:
the assembly of colloidal nanoparticles which are attached to an electret substrate, having a freely chosen and predetermined geometric shape, is a multilayer assembly of a certain number NI of layers, each of the layers of which is compact in terms of absence of undesired gaps with sizes greater than the size of two adjacent nanoparticles, preferably greater than the size of one nanoparticle, and
the absolute value of the surface electric potential and the concentration of polarizable nanoparticles are respectively greater than or equal to a fifth surface electric potential threshold and to a sixth concentration threshold, the fifth and sixth thresholds each depending on the nature of the dispersing medium, on the nature of the polarizable nanoparticles and on the number of layers, so that
after the contacting time, the micro/nanostructure obtained is the multilayer micro/nanostructure having the desired geometric shape, all the layers of which are compact in terms of absence of undesired gaps with a size greater than or equal to the size of two adjacent nanoparticles, preferably greater than or equal to the size of one nanoparticle, the nanoparticles being bonded to one another and/or to the substrate under the action of dielectrophoretic forces created from the interaction between the polarizable nanoparticles and the written surface potential.

4. A process for the manufacture of a binary micro/nanostructure formed of two types of colloidal nanoparticles, comprising:
a first monolayer assembly of colloidal nanoparticles of the first type, which are attached to an electret substrate, having a first freely chosen and predetermined geometric shape, and
a second monolayer or multilayer assembly of colloidal nanoparticles of the second type, which are attached to an electret substrate, having a second freely chosen and predetermined geometric shape, the process comprising the stages consisting in:
in a first stage (504), providing an electret substrate composed of an electret material and having a free receiving surface, then
in a second stage (506), writing, sequentially or in parallel, a surface electric potential on the receiving surface of the electret substrate according to a predetermined pattern of electric charges having a first sign and of electric charges having a second sign opposite the first, the pattern of charges being composed of a first subpattern of charges of the first sign, corresponding to the first monolayer assembly of nanoparticles of the first type, and of a second subpattern of charges of the second sign, corresponding to the second monolayer or multilayer assembly of nanoparticles of the second type,
in a third stage (508), bringing the electret substrate having the receiving surface written with the surface potential into contact with a first colloidal dispersion for a first contacting time,
the first colloidal dispersion comprising nanoparticles of the first type electrically charged according to the second sign and a first dispersing medium in the form of a liquid solvent or of a gas and the first contacting time being sufficiently long to allow the formation, on the first subpattern of charges written in the electret substrate, of the first monolayer assembly, having the desired first geometric shape, of nanoparticles of the first type bonded to the substrate under the action of electrophoretic forces created from the Coulomb interaction between the nanoparticles of the first type and the surface potential of the first subpattern of charges, then
in a fourth stage (510), drying the electret substrate and the first assembly, together forming an intermediate micro/nanostructure of end of third stage, by removing the first dispersing medium, then
in a fifth stage (512), bringing the dried intermediate structure into contact with a second colloidal dispersion for a second contacting time,
the second colloidal dispersion comprising colloidal nanoparticles of the second type which are electrically substantially neutral and polarizable electrically under the action of an external electric field and a second dispersing medium in the form of a liquid solvent or of a gas, substantially devoid of an electrical polarization action, in which the colloidal nanoparticles of the second type are dispersed, and
the absolute value of the surface electric potential and the concentration of nanoparticles of the second type being respectively greater than or equal to a first surface electric potential threshold and greater than or equal to a second concentration threshold, the first and second thresholds each depending on the nature of the second dispersing medium and on the nature of the polarizable nanoparticles of the second type, so that
after the second contacting time, which is sufficiently long and less than 15 minutes, the second assembly obtained is the second monolayer or multilayer assembly having the second desired geometric shape, and at least the first layer of which is compact in terms of absence of undesired gaps with a size greater than or equal to the size of two adjacent nanoparticles, preferably greater than or equal to the size of one nanoparticle, the nanoparticles being bonded to one another and/or to the substrate under the action of dielectrophoretic forces created from the interaction between the polarizable nanoparticles and the surface potential of the second subpattern.

5. A process for the manufacture of a binary micro/nanostructure formed of two types of colloidal nanoparticles comprising:
a first monolayer or multilayer assembly of colloidal nanoparticles of the first type, which are attached to an electret substrate, having a first freely chosen and predetermined geometric shape, and
a second monolayer or multilayer assembly of colloidal nanoparticles of the second type, which are attached to an electret substrate, having a second freely chosen and predetermined geometric shape, the process comprising the stages consisting in:
in a first stage (604), providing an electret substrate composed of an electret material and having a free receiving surface, then
in a second stage (606), writing, sequentially or in parallel, a first surface electric potential on the receiving surface of the electret substrate according to a first predetermined subpattern of electric charges having a first sign, corresponding to the first assembly of nanoparticles of the first type, the first subpattern making up a first part of a pattern of charges which also comprises a second predetermined subpattern of electric charges having a second sign opposite the first sign,
in a third stage (608), bringing the electret substrate having the receiving surface written with the first surface potential into contact with a first colloidal dispersion for a first contacting time of less than or equal to 15 minutes,
the first colloidal dispersion comprising nanoparticles of the first type, either electrically charged according to the second sign or substantially neutral and electrically polarizable, and a first dispersing medium in the form of a liquid solvent or of a gas and the first contacting time being sufficiently long to allow the formation, on the first subpattern of charges written in the electret substrate, of the first assembly, having the first monolayer or multilayer geometric shape, of nanoparticles of the first type bonded to the substrate, either under the action of electrophoretic forces created from the Coulomb interaction between the nanoparticles of the first type and the surface potential of the first subpattern of charges, when the nanoparticles of the first type are electrically charged according to the second sign, or under the action of dielectrophoretic forces created from the interaction between the polarizable nanoparticles and the surface potential of the first subpattern of charges when the nanoparticles of the first type are substantially neutral and electrically polarizable,
in a fourth stage (610), drying the electret substrate and the first assembly, together forming an intermediate micro/nanostructure of end of third stage (608), then,
in a fifth stage (612), writing, sequentially or in parallel, a second surface electric potential on the receiving surface of the electret substrate of the dried intermediate structure outside the regions covered by the first assembly, according to the second predetermined subpattern of electric charges having the second sign, then
in a sixth stage (614), bringing the intermediate structure written with the second surface potential into contact with a second colloidal dispersion for a second contacting time,
the second colloidal dispersion comprising colloidal nanoparticles of the second type, which are electrically neutral or quasineutral and electrically polarizable under the action of an external electric field, and a second dispersing medium in the form of a liquid solvent or of a gas, which is substantially devoid of an electrical polarization action, in which the colloidal nanoparticles are dispersed, and
the value of the electric surface potential and the concentration of nanoparticles of the second type being respectively greater than or equal to a first surface electric potential threshold and greater than or equal to a second concentration threshold, the first and second thresholds each depending on the nature of the second dispersing medium and on the nature of the polarizable nanoparticles of the second type, so that,
after the second contacting time, the second assembly obtained is the second monolayer or multilayer assembly having the second desired geometric shape, at least the first layer of which is compact in terms of absence of undesired gaps with a size greater than or equal to the size of two adjacent nanoparticles of the second type, preferably greater than or equal to the size of one nanoparticle of the second type, the nanoparticles being bonded to one another and/or to the substrate under the action of dielectrophoretic forces created from the interaction between the polarizable nanoparticles and the surface potential of the second subpattern.

6. The process for the manufacture of a binary microstructure of colloidal nanoparticles as claimed in claim 4 or claim 5, in which the colloidal nanoparticles of the first type have the property of converting radiation in the near infrared (NIR) spectrum into radiation in a first visible spectrum, and the nanoparticles of the second type have the property of converting the same radiation in the near infrared (NIR) spectrum into radiation in a second visible spectrum, the first visible spectrum being different from the second visible spectrum.

7. The process for the manufacture of a binary micro/nanostructure of colloidal nanoparticles as claimed in any one of claims 4 to 6, in which the concentration of charged nanoparticles of the first type, the first dispersing medium, the nanoparticles of the first type in terms of size, the first subpattern of charges, the first contacting time, the concentration of polarizable nanoparticles of the second type, the second dispersing medium, the nanoparticles of the second type in terms of size and polarizability and the second contacting time are chosen in order to obtain the first assembly having the first geometric shape and the second assembly having the desired second geometric shape, the first and second geometric shapes being conjugate shapes having the same height with respect to the receiving surface of the substrate, so that the geometric shape of the first assembly and the geometric shape of the second separate assembly are undetectable topographically by AFM or by optical microscopy using illumination in the visible spectrum.

8. The process for the manufacture of a micro/nanostructure of colloidal nanoparticles as claimed in any one of claims 1 to 7, in which the stage of writing the surface electric potential on the receiving surface of the electret substrate according to a pattern of charges is carried out according to preference,
by a process of sequential writing of positive and/or negative charges on the electret substrate included within the group formed by inscription of electric charges by a beam of focused ions, inscription of electric charges by a beam of focused electrons, inscription of electric charges by atomic force microscopy (AFM) and inscription of electric charges by electrophotography,
by a process of writing in parallel of positive and/or negative charges on the electret substrate included within the group formed by electrical nanoimprinting and electrical microcontact.

9. The process for the manufacture of a micro/nanostructure of colloidal nanoparticles as claimed in any one of claims 1 to 8, in which:
the electret material is a material included within the group formed by polymethyl methacrylates (PMMA), cyclic olefin copolymers (COC), polyethylene terephthalates (PET), polydimethylsiloxanes (PDMS), polypropylenes (PP), polycarbonates (PC), polystyrenes (PS), polyvinyl chlorides (PVC), polytetrafluoroethylenes (PFTE), triglycine sulfate (TGS), polyvinylidene fluoride (PVDF), silicon nitride (Si₃N₄), silicon oxide (SiO₂), or the compound Si₃N₄/SiO₂/Si (NOS);
the substantially neutral and electrically polarizable colloidal nanoparticles are compounds stabilized by themselves or by ligands and/or charges, having physical properties included within the group formed by plasmonic, conducting, magnetic, luminescent, catalytic, electrochromic or photochromic properties, rendered substantially neutral and electrically polarizable, produced from base colloidal nanoparticles,
the base colloidal nanoparticles having a solid core and, if appropriate, a shell and being included within the group formed by the latex, SiO₂, TiO₂, ZrO₂; CdS, CdSe, PbSe, GaAs, GaN, InP, In₂O₃, ZnS, ZnO, MoS₂, Si, C, ITO, Fe₂O₃, Fe₃O₄, Co, Fe-Co, Fe₃C, Fe₅C₂, Ni; Au, Ag, Cu, Pt, and the bimetallic nanoparticles; WO₃; NaLnF₄, the lanthanide fluorides (LnF₃), the lanthanide oxides (Ln₂O₃), the zirconates, silicates, hydroxides (Ln(OH)₃) and the sulfides of oxides doped or not doped with one or more different lanthanides (Ln denoting a lanthanide), the mixtures of these compounds, and the dispersing medium for the polarizable nanoparticles is, according to preference, a liquid solvent or a nonpolarizing gas,
the liquid solvent being included within the group formed by pentane, isopentane, hexane, heptane, octane, nonane, decane, cyclopentane, cyclohexane, cycloheptane, cyclooctane, cyclohexene, benzene, toluene, methylcyclohexane, xylene, mesitylene, chloroform, methylene chloride or tetrachloroethylene,
the nonpolarizing dispersing gas being included within the group formed by molecular nitrogen N₂, argon Ar and air.

10. The process for the manufacture of a micro/nanostructure of colloidal nanoparticles as claimed in any one of claims 1 to 9, comprising the additional stages consisting in:
choosing and locating by spatial coordinates on the electret substrate where the assembly has been formed a surface region not covered by the assembly to which nanoparticles have been attached in a chance and uncontrolled manner, in the form of a structure resulting from deposition noise, having a distribution which is not very dense in terms of compactness, random and dependent on the sample of the electret substrate on which the assembly has been formed, then
capturing an image of the random structure of the nanoparticles deposited in the chosen surface region and forming a signature, the captured image being according to preference an AFM topographical image, an optical image or a photoluminescence image, then
saving in a memory the captured image and the spatial coordinates of the corresponding surface region.

11. A micro/nanostructure formed of colloidal nanoparticles comprising:
an electret substrate composed of an electret material and having a free receiving surface, in which a surface electric potential is written on the receiving surface of the electret substrate according to a pattern of positive and/or negative electric charges,
an assembly of colloidal nanoparticles which are attached to the electret substrate, having a geometric shape,
wherein:
the colloidal nanoparticles are substantially neutral and polarizable electrically under the action of an external electric field, and
the polarizable nanoparticles are positioned as a multilayers, being directly bonded to one another and/or to the substrate under the action of dielectrophoretic forces created by the interaction existing between the polarizable nanoparticles and the surface potential of the pattern of charges, and
the pattern of electric charges of the same polarity written in the electret substrate corresponds to the geometric shape of the multilayerassembly of nanoparticles, **characterized in that**
the absolute value of the surface electric potential created by the pattern of charges is greater than or equal to a first surface electric potential threshold which depends on the nature of the polarizable nanoparticles and such that at least the first layer of the assembly of colloidal nanoparticles is compact in terms of absence of undesired gaps with a size greater than the size of two adjacent nanoparticles, preferably greater than the size of one nanoparticle.

12. The micro/nanostructure formed of colloidal nanoparticles as claimed in claim 11, in which:
the absolute value of the surface electric potential created by the pattern of charges is greater than or equal to a third threshold which depends on the nature of the polarizable nanoparticles, and such that the assembly is a multilayer assembly.

13. A micro/nanostructure formed of colloidal nanoparticles of two different types comprising, in the form of a binary assembly,
an electret substrate composed of an electret material and having a free receiving surface,
a first monolayer or multilayer assembly of colloidal nanoparticles of the first type, which are attached to the electret substrate,
a second monolayer or multilayer assembly of colloidal nanoparticles of the second type, which are attached to the electret substrate,
**characterized in that**:
the electret substrate comprises a surface electric potential written on the receiving surface of the electret substrate according to a predetermined pattern of electric charges having a first sign and having a second sign opposite the first sign, the pattern of charges being composed of a first subpattern of charges of the first sign and of a second subpattern of charges of the second sign, and
the nanoparticles of the first type forming the first monolayer or multilayer assembly are either electrically charged according to the second sign and bonded to the electret substrate under the action of Coulomb forces created by the interaction existing between the nanoparticles of the first type and the surface potential of the first subpattern of charges written in the electret substrate or substantially neutral and electrically polarizable and bonded to one another and/or to the substrate under the action of dielectrophoretic forces created from the interaction existing between the nanoparticles of the first type and the surface potential of the first subpattern of charges written in the electret substrate, and
the colloidal nanoparticles of the second type forming the second monolayer or multilayer assembly are substantially neutral and polarizable electrically under the action of an external electric field and bonded to one another and/or to the substrate under the action of dielectrophoretic forces created from the interaction existing between the nanoparticles of the second type and the surface potential of the second subpattern of charges written in the electret substrate, and
the second subpattern of electric charges of the second sign written in the electret substrate corresponds to the geometric shape of the second monolayer or multilayer assembly of nanoparticles, and
the absolute value of the surface electric potential created by the pattern of charges is greater than a first surface electric potential threshold which depends on the nature of the polarizable nanoparticles, and such that at least the first layer of the second assembly of colloidal nanoparticles is compact in terms of absence of undesired gaps with sizes greater than or equal to the size of two adjacent nanoparticles, preferably greater than or equal to the size of one nanoparticle.

14. The micro/nanostructure formed of colloidal nanoparticles of two different types as claimed in claim 13, in which:
the nanoparticles of the first type and the nanoparticles of the second type respectively have a first size and a second size, and
the first and second assemblies respectively have a first number and a second number of layers, and
the product of the first number of layers by the first size and the product of the second number of layers by the second size are substantially equal, and
the shapes of the first and second subpatterns of voltage in terms of intensity coding, of sign of the potential on the receiving surface of the electret substrate are configured so that the first and second geometric shapes respectively of the first assembly and of the second assembly are conjugate shapes and have substantially the same height with respect to the receiving surface of the substrate, thus rendering the geometric shape of the first assembly and the geometric shape of the second assembly undetectable separately topographically by AFM and/or by optical microscopy using illumination in the visible spectrum.

15. The micro/nanostructure of colloidal nanoparticles of two different types as claimed in claim 13 or 14, in which:
the nanoparticles of the first type have the property of converting radiation in the near infrared (NIR) spectrum into radiation in a first visible spectrum and the nanoparticles of the second type have the property of converting the same radiation in the near infrared (NIR) spectrum into radiation in a second visible spectrum, the first visible spectrum being different from the second visible spectrum.

16. An anticounterfeiting and/or traceability and/or authentication label comprising a micro/nanostructure of colloidal nanoparticles defined as claimed in any one of claims 11 to 15 or obtained by the process defined as claimed in any one of claims 1 to 10.

17. The anticounterfeiting and/or traceability and/or authentication label as claimed in claim 16, additionally comprising:
a structure of nanoparticles which are attached in chance and uncontrolled manner according to a deposition noise, having a distribution which is not very dense in terms of compactness and random, produced on a surface region of the electret substrate which is not covered by the assembly and located on the electret substrate by spatial coordinates, and
an image of said random structure of nanoparticles which are deposited on the located surface region, the captured image being according to preference an AFM topographical image, an optical image or a photoluminescence image and being stored in a memory.

18. The anticounterfeiting and/or traceability and/or authentication label as claimed in claim 17, in which
the coordinates of the image of said random structure are saved on an information medium corresponding to the image of said random structure.
